# EUROPEAN PATENT APPLICATION

(11) **EP 3 933 927 A1**
(43) Date of publication of application: **05.01.2022**
(21) Application number: 20762172.3
(22) Date of filing: 14.02.2020
(51) Int. Cl.: H01L 27/146, H01L 21/76, H01L 21/762, H04N 5/369, H04N 9/07

(54) **SOLID-STATE IMAGING DEVICE AND ELECTRONIC APPARATUS**

(30) Priority: 25.02.2019 JP 2019031319
(71) Applicant: Sony Semiconductor Solutions Corporation, Atsugi-shi, Kanagawa 243-0014 (JP)
(72) Inventor: OGASAHARA, Takayuki, Atsugi-shi, Kanagawa 243-0014 (JP); YOKOCHI, Kaito, Atsugi-shi, Kanagawa 243-0014 (JP)
(74) Representative: MFG Patentanwälte Meyer-Wildhagen Meggle-Freund Gerhard PartG mbB
(86) International application number: PCT/JP2020/005874
(87) International publication number: WO 2020/175195

(57) **Abstract**

A solid-state imaging device (1) according to the present disclosure includes a semiconductor layer (20), a plurality of on-chip lenses (50), a first separation region (22), and a second separation region (23). The semiconductor layer (20) is provided with a plurality of photoelectric conversion units. The plurality of on-chip lenses (50) causes light (L) to be incident on the corresponding photoelectric conversion units. The first separation region (22) separates the plurality of photoelectric conversion units on which the light (L) is incident through the same on-chip lens (50). The second separation region (23) separates the plurality of photoelectric conversion units on which light is incident through the different on-chip lenses (50). In addition, the first separation region (22) has a higher refractive index than the second separation region (23).

## Description

### Field

The present disclosure relates to a solid-state imaging device and an electronic device.

### Background

In recent years, there is a technology for realizing detection of a phase difference by causing light to be incident from the same on-chip lens into a plurality of photodiodes (see, for example, Patent Literature 1) in backside-illumination type complementary metal oxide semiconductor (CMOS) image sensors.

### Citation List

### Patent Literature

Patent Literature 1: JP 2016-52041 A

### Summary

### Technical Problem

In the above-described related art, however, there is a case where the incident light is greatly scattered in a separation region provided between the plurality of photodiodes since the light is incident on the plurality of photodiodes from the same on-chip lens. Then, when the greatly scattered light is incident on another photodiode, there is a possibility that color mixing may occur in a pixel array unit.

Therefore, the present disclosure proposes a solid-state imaging device and an electronic device capable of suppressing the occurrence of color mixing.

### Solution to Problem

According to the present disclosure, a solid-state imaging device is probided. The solid-state imaging device includes a semiconductor layer, a plurality of on-chip lenses, a first separation region, and a second separation region. The semiconductor layer is provided with a plurality of photoelectric conversion units. The plurality of on-chip lenses causes light to be incident on the corresponding photoelectric conversion units. The first separation region separates the plurality of photoelectric conversion units on which the light is incident through the same on-chip lens. The second separation region separates the plurality of photoelectric conversion units on which light is incident through the different on-chip lenses. In addition, the first separation region has a higher refractive index than the second separation region.

### Advantageous Effects of Invention

According to the present disclosure, it is possible to provide the solid-state imaging device and the electronic device capable of suppressing the occurrence of color mixing. Note that the effects described here are not necessarily limited, and may be any of the effects described in the present disclosure.

### Brief Description of Drawings

FIG. 1 is a system configuration diagram illustrating a schematic configuration example of a solid-state imaging device according to an embodiment of the present disclosure.
FIG. 2 is a plan view for describing an arrangement of a unit pixel, a color filter, and an on-chip lens of a pixel array unit according to the embodiment of the present disclosure.
FIG. 3 is a cross-sectional view taken along line A-A illustrated in FIG. 2.
FIG. 4 is a view for describing a light scattering state in a pixel array unit according to a reference example.
FIG. 5 is a view for describing a light scattering state in the pixel array unit according to the embodiment of the present disclosure.
FIG. 6 is a circuit diagram illustrating a circuit configuration of the unit pixel according to the embodiment of the present disclosure.
FIG. 7 is a view for describing a structure of a second separation region of a pixel array unit according to a first modification of the embodiment of the present disclosure.
FIG. 8 is a view for describing a structure of a first separation region of the pixel array unit according to the first modification of the embodiment of the present disclosure.
FIG. 9 is an enlarged cross-sectional view illustrating a cross-sectional structure of a pixel array unit according to a second modification of the embodiment of the present disclosure.
FIG. 10 is an enlarged cross-sectional view illustrating a cross-sectional structure of a pixel array unit according to a third modification of the embodiment of the present disclosure.
FIG. 11 is an enlarged cross-sectional view illustrating a cross-sectional structure of a pixel array unit according to a fourth modification of the embodiment of the present disclosure.
FIG. 12 is an enlarged cross-sectional view illustrating a cross-sectional structure of a pixel array unit according to a fifth modification of the embodiment of the present disclosure.
FIG. 13 is an enlarged cross-sectional view illustrating a cross-sectional structure of a pixel array unit according to a sixth modification of the embodiment of the present disclosure.
FIG. 14 is an enlarged cross-sectional view illustrating a cross-sectional structure of a pixel array unit according to a seventh modification of the embodiment of the present disclosure.
FIG. 15 is an enlarged cross-sectional view illustrating a cross-sectional structure of a pixel array unit according to an eighth modification of the embodiment of the present disclosure.
FIG. 16 is a plan view for describing an arrangement of a unit pixel, a color filter, and an on-chip lens of a pixel array unit according to a ninth modification of the embodiment of the present disclosure.
FIG. 17 is a cross-sectional view taken along line B-B illustrated in FIG. 16.
FIG. 18 is a plan view for describing an arrangement of a unit pixel, a color filter, and an on-chip lens of a pixel array unit according to a tenth modification of the embodiment of the present disclosure.
FIG. 19 is a cross-sectional view taken along line C-C illustrated in FIG. 18.
FIG. 20 is a plan view for describing an arrangement of a unit pixel, a color filter, and an on-chip lens of a pixel array unit according to an eleventh modification of the embodiment of the present disclosure.
FIG. 21 is a cross-sectional view taken along line D-D illustrated in FIG. 20.
FIG. 22 is a plan view for describing an arrangement of a unit pixel, a color filter, and an on-chip lens of a pixel array unit according to a twelfth modification of the embodiment of the present disclosure.
FIG. 23 is a cross-sectional view taken along line E-E illustrated in FIG. 22.
FIG. 24 is a plan view for describing an arrangement of a pixel group and a light collection point of a pixel array unit according to a thirteenth modification of the embodiment of the present disclosure.
FIG. 25 is a block diagram illustrating a configuration example of an imaging device as an electronic device to which the technology according to the present disclosure is applied.
FIG. 26 is a block diagram illustrating an example of a schematic configuration of a vehicle control system.
FIG. 27 is an explanatory diagram illustrating an example of an installation position of an external vehicle information detection unit and an imaging unit.
FIG. 28 is a diagram illustrating an example of a schematic configuration of an endoscopic surgery system.
FIG. 29 is a block diagram illustrating an example of a functional configuration of a camera head and a CCU.

### Description of Embodiments

Hereinafter, each embodiment of the present disclosure will be described in detail with reference to the drawings. Note that the same portions are denoted by the same reference signs in each of the following embodiments, and a repetitive description thereof will be omitted.

In recent years, there is a technology for realizing detection of a phase difference by causing light to be incident from the same on-chip lens into a plurality of photodiodes in backside-illumination type complementary metal oxide semiconductor (CMOS) image sensors.

In the above-described related art, however, there is a case where the incident light is greatly scattered in a separation region provided between the plurality of photodiodes since the light is incident on the plurality of photodiodes from the same on-chip lens.

For example, when such a separation region is made of a dielectric (for example, SiO₂), there is a case where light is greatly scattered due to a large difference in refractive index between the dielectric and a silicon substrate at an end of this separation region on the light incident side. Then, when the greatly scattered light is incident on another photodiode, there is a possibility that color mixing may occur in a pixel array unit.

Therefore, it is expected to realize a solid-state imaging device provided with a pixel array unit capable of suppressing the occurrence of color mixing.

### [Configuration of Solid-State Imaging Device]

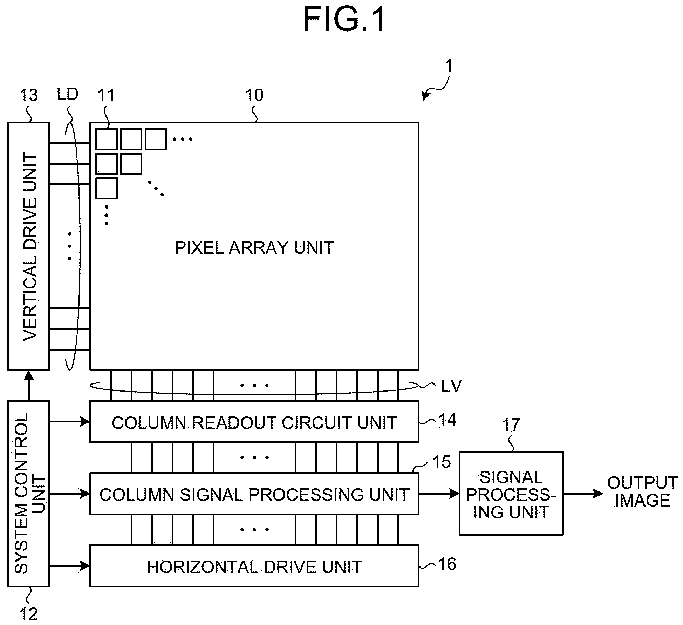

FIG. 1 is a system configuration diagram illustrating a schematic configuration example of a solid-state imaging device 1 according to an embodiment of the present disclosure. As illustrated in FIG. 1, the solid-state imaging device 1, which is a CMOS image sensor, includes a pixel array unit 10, a system control unit 12, a vertical drive unit 13, a column readout circuit unit 14, a column signal processing unit 15, a horizontal drive unit 16, and a signal processing unit 17.

The pixel array unit 10, the system control unit 12, the vertical drive unit 13, the column readout circuit unit 14, the column signal processing unit 15, the horizontal drive unit 16, and the signal processing unit 17 are provided on the same semiconductor substrate or on a plurality of stacked semiconductor substrates which are electrically connected.

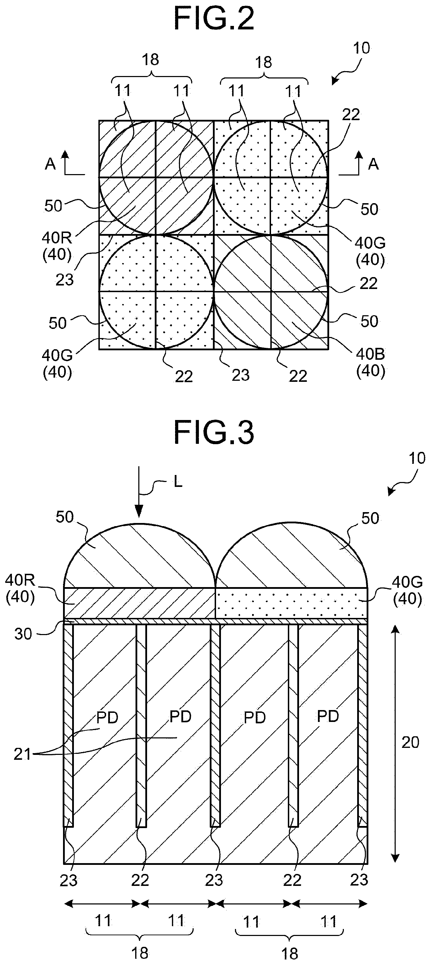

In the pixel array unit 10, effective unit pixels (hereinafter, also referred to as "unit pixels") 11 each having a photoelectric conversion element (photodiode 21 (see FIG. 3)), which can photoelectrically convert the amount of electric charge corresponding to the amount of incident light, accumulate the electric charge therein, and output the electric charge as a signal, are arranged two-dimensionally in a matrix.

In addition, the pixel array unit 10 sometimes include a region in which a dummy unit pixel having a structure that does not include the photodiode 21, a light-shielding unit pixel that blocks a light-receiving surface to block light incidence from the outside, and the like are arranged in rows and/or columns, in addition to the effective unit pixel 11.

Note that the light-shielding unit pixel may have the same configuration as the effective unit pixel 11 except that the light-receiving surface is shielded from light. In addition, hereinafter, photoelectric charge having an amount of electric charge corresponding to the amount of incident light is simply referred to as "charge", and the unit pixel 11 is simply referred to as a "pixel" in some cases.

In the pixel array unit 10, a pixel drive line LD is formed along the left-and-right direction of the drawing for each row of the pixel array in a matrix (array direction of pixels in a pixel row), and a vertical pixel wiring LV is formed along the up-and-down direction of the drawing for each column (array direction of pixels in each pixel column). One end of the pixel drive line LD is connected to an output end corresponding to each row of the vertical drive unit 13.

The column readout circuit unit 14 includes at least a circuit that supplies a constant current for each column to the unit pixel 11 in a selected row in the pixel array unit 10, a current mirror circuit, and a change-over switch for the unit pixel 11 to be read.

Then, the column readout circuit unit 14 forms an amplifier together with a transistor in the selected pixel in the pixel array unit 10, converts a photoelectric charge signal into a voltage signal, and outputs the photoelectric charge signal to the vertical pixel wiring LV.

The vertical drive unit 13 includes a shift register, an address decoder, and the like, and drives each of the unit pixels 11 of the pixel array unit 10 at the same time for all pixels or in units of rows. The vertical drive unit 13 includes a read-out scanning system and a sweep scanning system or a batch sweep and batch transfer system although a specific configuration thereof is not illustrated.

The read-out scanning system selectively scans the unit pixels 11 of the pixel array unit 10 in units of rows in order to read out a pixel signal from the unit pixel 11. In the case of row drive (a rolling shutter operation), for sweep, sweep scanning is performed for a read-out row for which read-out scanning is performed by the read-out scanning system earlier than the read-out scanning by the time of shutter speed.

In addition, in the case of global exposure (a global shutter operation), batch sweep is performed earlier than batch transfer by the time of shutter speed. With such sweep, unnecessary charge is swept (reset) from the photodiode 21 of the unit pixel 11 in the read-out row. Then, a so-called electronic shutter operation is performed by sweeping (resetting) the unnecessary charge.

Here, the electronic shutter operation refers to an operation of discarding unnecessary photoelectric charge accumulated in the photodiode 21 until just before then and starting new light exposure (starting the accumulation of photoelectric charge).

A signal read out by a read-out operation of the read-out scanning system corresponds to the amount of light incident during an immediately previous read-out operation or after the electronic shutter operation. In the case of row drive, a period from a read-out timing by the immediately previous read-out operation or a sweep timing by the electronic shutter operation to a read-out timing by the current read-out operation is the photoelectric charge accumulation time (exposure time) in the unit pixel 11. In the case of global exposure, the time from batch sweeping to batch transfer is the accumulation time (exposure time).

A pixel signal output from each of the unit pixels 11 in the pixel row selectively scanned by the vertical drive unit 13 is supplied to the column signal processing unit 15 through each of the vertical pixel wirings LV. The column signal processing unit 15 performs predetermined signal processing on the pixel signal output from each of the unit pixels 11 in the selected row through the vertical pixel wiring LV for each pixel column of the pixel array unit 10, and temporarily holds the pixel signal after having been subjected to the signal processing.

Specifically, the column signal processing unit 15 performs at least noise removal processing, for example, correlated double sampling (CDS) processing, as the signal processing. With the CDS processing in the column signal processing unit 15, fixed pattern noise peculiar to a pixel, such as reset noise and a threshold variation of an amplification transistor AMP, is removed.

Note that the column signal processing unit 15 can be also provided with, for example, an AD conversion function, in addition to the noise removal processing, so as to output the pixel signal as a digital signal.

The horizontal drive unit 16 includes a shift register, an address decoder, and the like, and sequentially selects unit circuits corresponding to pixel strings of the column signal processing unit 15. With the selective scanning in the horizontal drive unit 16, pixel signals which have been signal-processed by the column signal processing unit 15 are sequentially output to the signal processing unit 17.

The system control unit 12 includes a timing generator that generates various timing signals and the like, and performs drive control of the vertical drive unit 13, the column signal processing unit 15, the horizontal drive unit 16, and the like based on the various timing signals generated by the timing generator.

The solid-state imaging device 1 further includes the signal processing unit 17 and a data storage unit (not illustrated). The signal processing unit 17 has at least an addition processing function, and performs various types of signal processing such as addition processing on a pixel signal output from the column signal processing unit 15.

For the signal processing in the signal processing unit 17, the data storage unit temporarily stores data required for the processing. These signal processing unit 17 and data storage unit may be realized by an external signal processing unit provided on a substrate different from the solid-state imaging device 1, for example, digital signal processor (DSP) or processing by software, or alternatively may be mounted on the same substrate as the solid-state imaging device 1.

### [Configuration of Pixel Array Unit]

Subsequently, a detailed configuration of the pixel array unit 10 will be described with reference to FIGS. 2 and 3. FIG. 2 is a plan view for describing an arrangement of the unit pixel 11, a color filter 40, and an on-chip lens 50 of the pixel array unit 10 according to the embodiment of the present disclosure, and FIG. 3 is a cross-sectional view taken along line A-A illustrated in FIG. 2.

As illustrated in FIG. 3 and the like, the pixel array unit 10 includes a semiconductor layer 20, a fixed charge film 30, a plurality of the color filters 40, and a plurality of the on-chip lenses 50.

The semiconductor layer 20 contains, for example, silicon. The semiconductor layer 20 has a plurality of the photodiodes (PD) 21. The photodiode 21 is an example of a photoelectric conversion unit. Note that one photodiode 21 is provided in one unit pixel 11. A circuit configuration example of the unit pixel 11 will be described later.

In addition, the semiconductor layer 20 has a plurality of first separation regions 22 and a plurality of second separation regions 23. The first separation region 22 separates a plurality of photodiodes 21 on which light L is incident through the same on-chip lens 50. On the other hand, the second separation region 23 separates a plurality of photodiodes 21 on which the light L is incident through different on-chip lenses 50.

In other words, when one pixel group 18 is constituted by a plurality of unit pixels 11 on which light L is incident through the same on-chip lens 50, the first separation region 22 is a separation region that separates the plurality of unit pixels 11 belonging to the same pixel group 18. On the other hand, the second separation region 23 is a separation region that separates a plurality of unit pixels 11 belonging to different pixel groups 18.

As illustrated in FIG. 3, the first separation region 22 and the second separation region 23 are formed in a wall shape so as to extend in the depth direction from a surface of the semiconductor layer 20 on the light incident side (that is, the on-chip lens 50 side), for example. In addition, the first separation region 22 and the second separation region 23 are formed so as not to penetrate the semiconductor layer 20.

Here, a refractive index of the first separation region 22 is set to be higher than a refractive index of the second separation region 23 in the embodiment. For example, the first separation region 22 is made of a dielectric having a high refractive index such as tantalum oxide (Ta₂O₅: refractive index = 2.2 (wavelength: 530 nm)) and titanium oxide (TiO₂: refractive index = 2.4 (wavelength: 530 nm)).

In addition, the second separation region 23 is made of a dielectric having a low refractive index such as silicon oxide (SiO₂: refractive index = 1.5 (wavelength: 530 nm)).

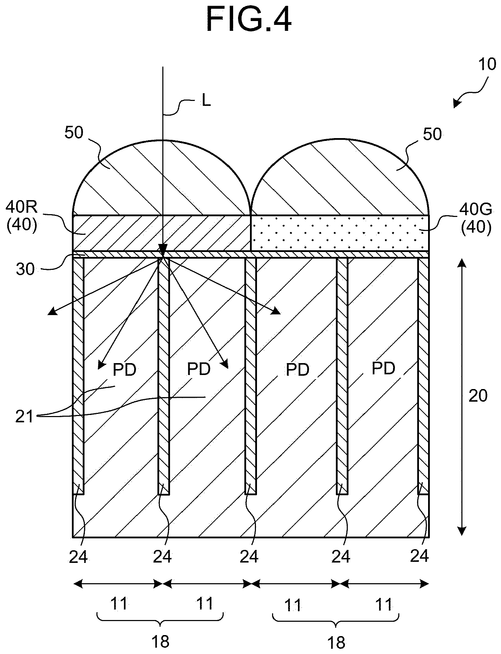

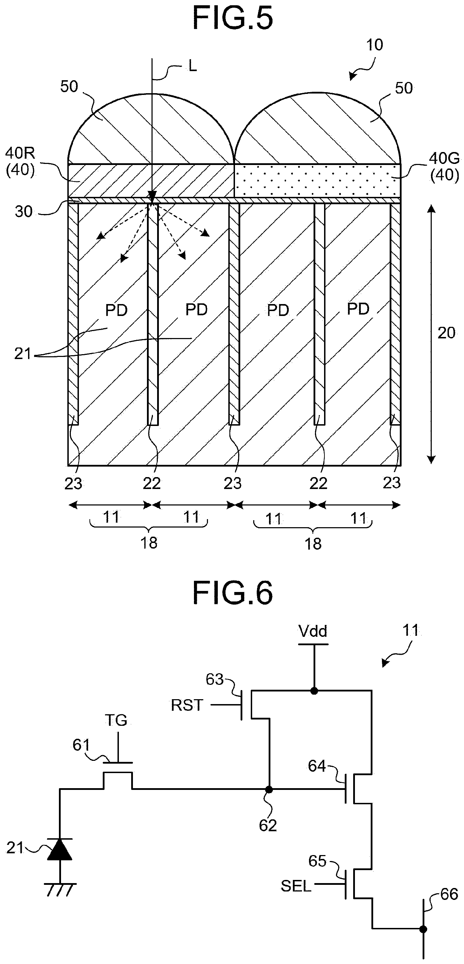

Here, an effect obtained by configuring the first separation region 22 and the second separation region 23 as described above will be described with reference to FIGS. 4 and 5. FIG. 4 is a view for describing a scattering state of the light L in the pixel array unit 10 according to a reference example.

The reference example illustrated in FIG. 4 illustrates a case where the plurality of photodiodes 21 are separated by separation regions 24 all having the same refractive index. Here, the separation region 24 preferably has a large difference in refractive index from the semiconductor layer 20 made of silicon (refractive index = 4.2 (wavelength: 530 nm)) in order to suppress the light L from leaking to the adjacent photodiode 21.

This is because the refraction at an interface is great as the difference in refractive index between the photodiode 21 and the separation region 24 increases, the light L traveling inside the photodiode 21 is totally reflected at the interface with respect to the separation region 24, and the proportion of returning to the same photodiode 21 increases.

That is, when considering that the adjacent photodiodes 21 are optically separated, it is preferable that all the separation regions 24 be made of a dielectric having a low refractive index (for example, SiO₂).

On the other hand, the light L is incident on the plurality of photodiodes 21 from the same on-chip lens 50 in the reference example as illustrated in FIG. 4, and thus, there is a case where the light L is incident on an end on the light incident side in the separation region 24 that separates the unit pixels 11 belonging to the same pixel group 18.

Then, the light L incident on the end of the separation region 24 on the light incident side is greatly scattered due to the large difference in refractive index from the photodiode 21, and leaks to another photodiode 21. As a result, there is a possibility that color mixing may occur in the pixel array unit 10 of the reference example.

FIG. 5 is a view for describing a scattering state of the light L in the pixel array unit 10 according to the embodiment of the present disclosure. As illustrated in FIG. 5, the first separation region 22 is made of a dielectric having a high refractive index, and the second separation region 23 is made of a dielectric having a low refractive index, in the embodiment.

Further, there is a case where the light L is incident on the end on the light incident side in the first separation region 22 that separates the plurality of unit pixels 11 belonging to the same pixel group 18 even in the pixel array unit 10 according to the embodiment similarly to the reference example.

However, a difference in refractive index between the first separation region 22 and the photodiode 21 is smaller than that of the reference example, and thus, the light L incident on the end of the first separation region 22 on the light incident side is not greatly scattered as illustrated in FIG. 5.

Therefore, it is possible to suppress the scattered light from leaking to another photodiode 21 according to the embodiment, and thus, it is possible to suppress the occurrence of color mixing due to the scattered light.

In addition, the second separation region 23 that separates the plurality of unit pixels 11 belonging to the different pixel groups 18 is made of the dielectric having the low refractive index in the embodiment. As a result, a difference in refractive index between the photodiode 21 and the second separation region 23 can be increased, and thus, the proportion of the light L totally reflected at an interface between the photodiode 21 and the second separation region 23 can be increased.

That is, it is possible to prevent the light L incident on the photodiode 21 from the on-chip lens 50 from leaking to another photodiode 21 in the embodiment. Therefore, it is possible to suppress the occurrence of color mixing due to the light L incident on the photodiode 21 according to the embodiment.

Note that the second separation region 23 is not arranged in a central portion of the on-chip lens 50 but is arranged in a peripheral edge portion of the on-chip lens 50 as illustrated in FIG. 2 and the like, and thus, the light L is hardly incident on the end of the second separation region 23 on the light incident side.

Therefore, the degree at which the light L is scattered in the end on the light incident side is very small, and thus, there is no practical problem even if the second separation region 23 is made of the dielectric having the low refractive index.

As described above, the first separation region 22 is made of the dielectric having the high refractive index, and the second separation region 23 is made of the dielectric having the low refractive index, and thus, it is possible to suppress the occurrence of color mixing in the embodiment. That is, the occurrence of color mixing can be suppressed according to the embodiment by setting the refractive index of the first separation region 22 to be higher than the refractive index of the second separation region 23.

For example, when the first separation region 22 is made of titanium oxide and the second separation region 23 is made of silicon oxide in the embodiment, a color mixing reduction effect of about 5% can be obtained (when an incident angle of the light L is 30°) as compared with the reference example in which the separation region 24 is made of silicon oxide.

In addition, the refractive index of the first separation region 22 at the wavelength of 530 nm is preferably 2.0 or more and less than 4.2 in the embodiment. As a result, the difference in refractive index between the first separation region 22 and the photodiode 21 can be further reduced, so that the occurrence of color mixing due to the scattered light can be further suppressed.

In addition, the refractive index of the second separation region 23 at the wavelength of 530 nm is preferably 1.0 or more and 1.5 or less in the embodiment. As a result, the difference in refractive index between the photodiode 21 and the second separation region 23 can be further increased, so that the occurrence of color mixing due to the light L incident on the photodiode 21 can be further suppressed.

Note that the second separation region 23 is not limited to the dielectric having the low refractive index, and may be made of, for example, air. That is, the second separation region 23 may be made of a trench filled with air without any embedding.

Returning to FIGS. 2 and 3, a description regarding other portions of the pixel array unit 10 will be continued. The fixed charge film 30 has a function of fixing charge (here, a hole) at an interface between the photodiode 21 and the color filter 40. As a material of the fixed charge film 30, it is preferable to use a highly dielectric material having a large amount of fixed charge.

The fixed charge film 30 is made of, for example, hafnium oxide (HfO₂), aluminum oxide (Al₂O₃), tantalum oxide, zirconium oxide (ZrO₂), titanium oxide, magnesium oxide (MgO₂), lanthanum oxide (La₂O₃), or the like.

In addition, the fixed charge film 30 may be made of praseodymium oxide (Pr₂O₃), cerium oxide (CeO₂), neodymium oxide (Nd₂O₃), promethium oxide (Pm₂O₃), samarium oxide (Sm₂O₃), europium oxide (Eu₂O₃), or the like.

In addition, the fixed charge film 30 may be made of gadolinium oxide (Gd₂O₃), terbium oxide (Tb₂O₃), dysprosium oxide (Dy₂O₃), holmium oxide (Ho₂O₃), erbium oxide (Er₂O₃), thulium oxide (Tm₂O₃), or the like.

In addition, the fixed charge film 30 is made of ytterbium oxide (Yb₂O₃), lutetium oxide (Lu₂O₃), yttrium oxide (Y₂O₃), aluminum nitride (AlN), hafnium oxynitride (HfON), an aluminum oxynitride film (AlON), or the like.

The color filter 40 is provided between the on-chip lens 50 and the fixed charge film 30, and has a red filter 40R, a green filter 40G, and a blue filter 40B. The red filter 40R is an example of the red color filter 40.

Then, any of the red filter 40R, the green filter 40G, and the blue filter 40B is arranged in accordance with the corresponding unit pixel 11 and on-chip lens 50.

In the embodiment, any one of the red filter 40R, the green filter 40G, and the blue filter 40B is provided for each of the on-chip lenses 50 as illustrated in FIG. 2. Note that, in the following drawings, the red filter 40R is hatched by diagonal lines sloping to the left, the green filter 40G is hatched by dots, and the blue filter 40B is hatched by diagonal lines sloping to the right, for ease of understanding.

In addition, the color filter 40 is provided with a regular color array (for example, a Bayer array). As a result, the pixel array unit 10 can acquire color light reception data corresponding to such a color array.

Note that the example in which the red filter 40R, the green filter 40G, and the blue filter 40B are provided as the color filter 40 is illustrated in the example of FIG. 2, but a white filter may be provided in addition to these.

The on-chip lens 50 is provided on the side where the light L is incident on the semiconductor layer 20, and has a function of collecting the light L toward the corresponding photodiode 21. The on-chip lens 50 is made of, for example, an organic material or silicon oxide.

In the embodiment, the unit pixels 11 in two rows and two columns are provided for each of the on-chip lenses 50 as illustrated in FIG. 2. That is, one pixel group 18 is constituted by the unit pixels 11 in two rows and two columns. Then, any one of the red filter 40R, the green filter 40G, and the blue filter 40B is provided for each of the pixel groups 18.

In the pixel array unit 10 having the configuration described so far, a phase difference can be detected by sharing the same on-chip lens 50 and color filter 40 between the pair of unit pixels 11 adjacent to each other in the left-right direction. Therefore, the solid-state imaging device 1 can be provided with an autofocus function of a phase difference detection system according to the embodiment.

Then, it is possible to suppress the occurrence of color mixing in the pair of unit pixels 11 that share the same on-chip lens 50 and color filter 40 as described above in the embodiment. Therefore, it is possible to improve the autofocus accuracy of the phase difference detection system in the solid-state imaging device 1 according to the embodiment.

In addition, a high dynamic range (HDR) function and a remosaic function can be added to the solid-state imaging device 1 since the same color filter 40 is shared by the unit pixels 11 in two rows and two columns according to the embodiment.

In addition, both the first separation region 22 and the second separation region 23 are provided so as not to penetrate the semiconductor layer 20 in the depth direction in the embodiment. As a result, it is unnecessary to penetrate the trench formed in the semiconductor layer 20 when forming the first separation region 22 and the second separation region 23, and thus, the manufacturing cost of the pixel array unit 10 can be reduced.

Note that a plurality of pixel transistors that read out the charge accumulated in the photodiodes 21 and a multilayer wiring layer including a plurality of wiring layers and interlayer insulating films are provided on a side of the semiconductor layer 20 opposite to the light incident side in FIG. 3, but none of them is illustrated.

### [Circuit Configuration Example of Unit Pixel]

Subsequently, a circuit configuration example of the unit pixel 11 will be described with reference to FIG. 6. FIG. 6 is a circuit diagram illustrating an example of the circuit configuration of the unit pixel 11 according to the embodiment of the present disclosure.

The unit pixel 11 includes the photodiode 21 as the photoelectric conversion unit, a transfer transistor 61, floating diffusion 62, a reset transistor 63, an amplification transistor 64, and a selection transistor 65.

The photodiode 21 generates and accumulates charge (signal charge) according to the amount of received light. The photodiode 21 has an anode terminal being grounded and a cathode terminal is connected to the floating diffusion 62 via the transfer transistor 61.

When the transfer transistor 61 is turned on by a transfer signal TG, the transfer transistor 61 reads out the charge generated by the photodiode 21 and transfers the charge to the floating diffusion 62.

The floating diffusion 62 holds the charge read from the photodiode 21. When the reset transistor 63 is turned on by a reset signal RST, the charge accumulated in the floating diffusion 62 is discharged to a drain (constant voltage source Vdd) to reset a potential of the floating diffusion 62.

The amplification transistor 64 outputs a pixel signal corresponding to a potential of the floating diffusion 62. That is, the amplification transistor 64 constitutes a source follower circuit with a load (not illustrated) as a constant current source connected via a vertical signal line 66.

Then, the amplification transistor 64 outputs a pixel signal indicating a level corresponding to the charge accumulated in the floating diffusion 62 to the column signal processing unit 15 (see FIG. 1) via the selection transistor 65.

The selection transistor 65 is turned on when the unit pixel 11 is selected by a selection signal SEL, and outputs the pixel signal generated by the unit pixel 11 to the column signal processing unit 15 via the vertical signal line 66. Each signal line through which the transfer signal TG, the selection signal SEL, and the reset signal RST are transmitted is connected to the vertical drive unit 13 (see FIG. 1).

The unit pixel 11 can be configured as described above, but is not limited to this configuration, and other configurations may be adopted. For example, the plurality of unit pixels 11 may have a shared pixel structure in which the floating diffusion 62, the reset transistor 63, the amplification transistor 64, and the selection transistor 65 are shared.

### [Various Modifications]

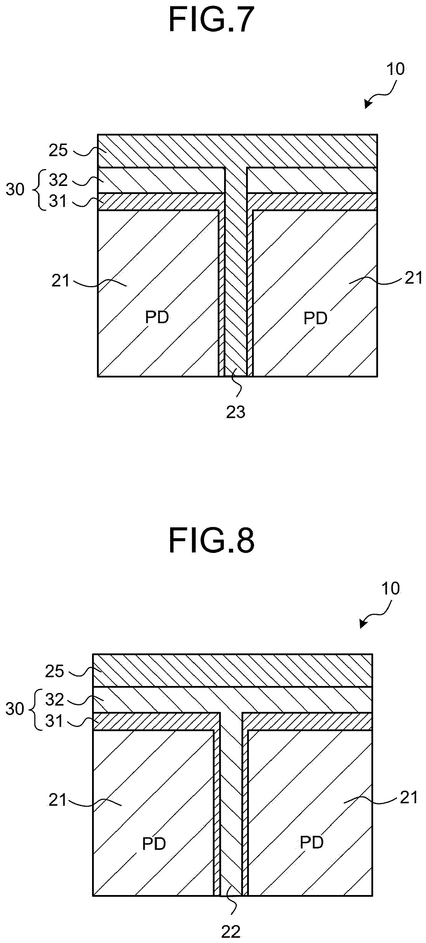

Subsequently, various modifications of the embodiment will be described with reference to FIGS. 7 to 24. FIG. 7 is a view for describing a structure of the second separation region 23 of the pixel array unit 10 according to a first modification of the embodiment of the present disclosure.

In the first modification, the fixed charge film 30 is made of stacked first fixed charge film 31 and second fixed charge film 32. The first fixed charge film 31 is a layer that is in direct contact with the photodiode 21, and is made of a dielectric having a large fixed charge (for example, aluminum oxide).

In addition, the first fixed charge film 31 is also provided on a side surface of the photodiode 21 (that is, between the photodiode 21 and the second separation region 23) in addition to a surface of the photodiode 21 on the light incident side.

The second fixed charge film 32 is a layer formed on the first fixed charge film 31 and is made of a dielectric having a high refractive index (for example, tantalum oxide or titanium oxide).

In addition, a silicon oxide film 25 is provided on the fixed charge film 30 in the first modification. Then, the silicon oxide film 25 is provided integrally with the second separation region 23. For example, the silicon oxide film 25 and the second separation region 23 can be integrally formed by forming the silicon oxide film 25 so as to fill a trench formed at a position corresponding to the second separation region 23.

FIG. 8 is a view for describing a structure of the first separation region 22 of the pixel array unit 10 according to the first modification of the embodiment of the present disclosure. As illustrated in FIG. 8, the first separation region 22 is provided integrally with the second fixed charge film 32 in the first modification. That is, the first separation region 22 contains the same material as the fixed charge film 30 (specifically, the second fixed charge film 32) in the first modification.

For example, the second fixed charge film 32 and the first separation region 22 can be integrally formed by forming the second fixed charge film 32 so as to fill the trench formed at the position corresponding to the first separation region 22.

Therefore, the second fixed charge film 32 and the first separation region 22 can be formed at the same time according to the first modification, so that the manufacturing cost of the pixel array unit 10 can be reduced.

In addition, the silicon oxide film 25 and the second separation region 23 can be formed at the same time in the first modification, so that the manufacturing cost of the pixel array unit 10 can be reduced.

Note that each thickness of the first separation region 22 and the second separation region 23 is preferably about 80 nm in the first modification. In addition, the thickness of the first fixed charge film 31 adjacent to the first separation region 22 or the second separation region 23 is preferably about 15 nm.

In addition, the example in which the first fixed charge film 31 is provided adjacent to the first separation region 22 or the second separation region 23 has been illustrated in the first modification, the first fixed charge film 31 adjacent to the first separation region 22 or the second separation region 23 is not necessarily provided.

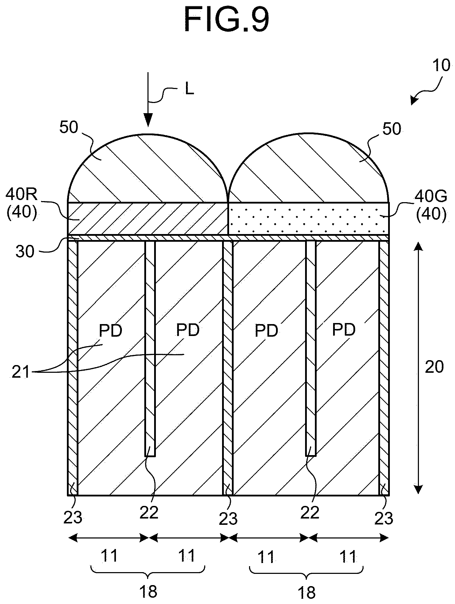

FIG. 9 is an enlarged cross-sectional view illustrating a cross-sectional structure of the pixel array unit 10 according to a second modification of the embodiment of the present disclosure. The second modification is different from the embodiment in that the second separation region 23 penetrates the semiconductor layer 20.

Since the second separation region 23 passes in the depth direction in this manner, the photodiodes 21 adjacent to each other between different colors can be optically separated from each other favorably. Therefore, the occurrence of color mixing can be further suppressed according to the second modification,

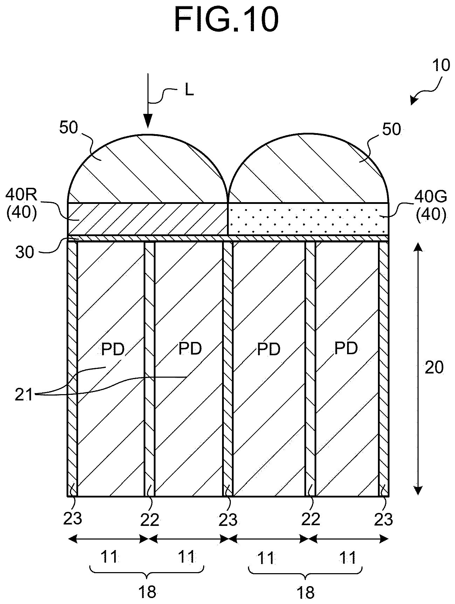

FIG. 10 is an enlarged cross-sectional view illustrating a cross-sectional structure of the pixel array unit 10 according to a third modification of the embodiment of the present disclosure. Such a third modification is different from the second modification in that both the first separation region 22 and the second separation region 23 penetrate the semiconductor layer 20.

As both the first separation region 22 and the second separation region 23 pass in the depth direction in this manner, all the adjacent photodiodes 21 can be optically separated from each other favorably. Therefore, the occurrence of color mixing can be further suppressed according to the third modification.

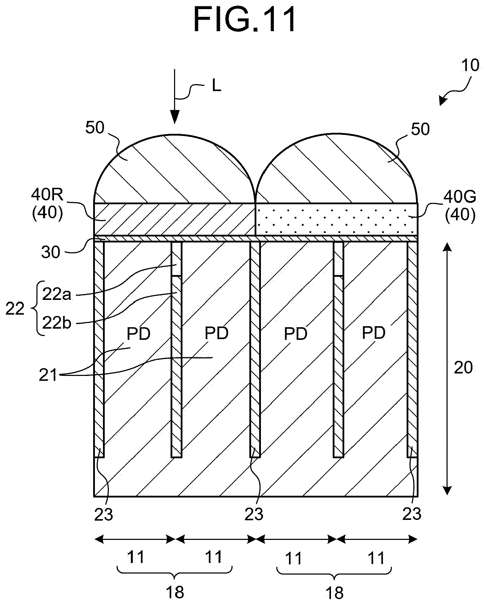

FIG. 11 is an enlarged cross-sectional view illustrating a cross-sectional structure of the pixel array unit 10 according to a fourth modification of the embodiment of the present disclosure. In the fourth modification, a structure of the first separation region 22 is different from that of the embodiment.

Specifically, an end 22a of the first separation region 22 on the light incident side is made of a dielectric having a high refractive index (for example, tantalum oxide or titanium oxide) as in the embodiment. On the other hand, a portion 22b other than the end 22a of the first separation region 22 is made of a dielectric having a low refractive index (for example, silicon oxide).

Here, a difference in refractive index between the end 22a of the first separation region 22 and the photodiode 21 is small, and thus, the light L incident on the end 22a of the first separation region 22 is not greatly scattered. Therefore, it is possible to suppress the occurrence of color mixing due to the scattered light according to the fourth modification.

In addition, since the portion 22b other than the end 22a on the light incident side is made of the dielectric having the low refractive index in the fourth modification, the proportion at which the light incident on the photodiode 21 is totally reflected at the first separation region 22 can be increased.

That is, it is possible to prevent the light incident on the photodiode 21 from leaking to the adjacent photodiode 21 via the first separation region 22 in the fourth modification. Therefore, the occurrence of color mixing due to the light L incident on the photodiode 21 can be further suppressed according to the fourth modification.

As described above, in the first separation region 22, the refractive index of the end 22a is set to be higher than the refractive index of the second separation region 23, and the refractive index of the portion 22b other than the end 22a is set to be lower than the refractive index of the end 22a in the fourth modification. As a result, both the occurrence of color mixing due to the scattered light and the occurrence of color mixing due to the light L incident on the photodiode 21 can be suppressed in the first separation region 22.

In addition, the depth of the end 22a of the first separation region 22 on the light incident side is preferably 20 nm or more and 100 nm or less in the fourth modification. As a result, both the occurrence of color mixing due to the scattered light and the occurrence of color mixing due to the light L incident on the photodiode 21 can be suppressed in a well-balanced manner in the first separation region 22.

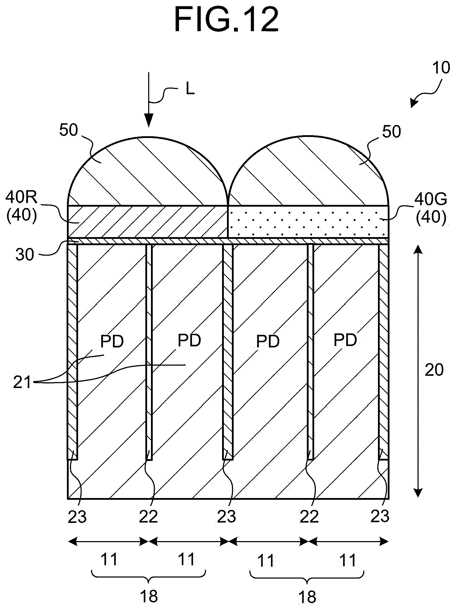

FIG. 12 is an enlarged cross-sectional view illustrating a cross-sectional structure of the pixel array unit 10 according to a fifth modification of the embodiment of the present disclosure. In the fifth modification, a structure of the first separation region 22 is different from that of the embodiment.

Specifically, the first separation region 22 has a smaller thickness than the second separation region 23. As a result, it is possible to reduce the area of a portion where the light L incident on an end of the first separation region 22 is scattered, so that it is possible to suppress the light L from being greatly scattered. Therefore, the occurrence of color mixing due to the scattered light can be further suppressed according to the fifth modification.

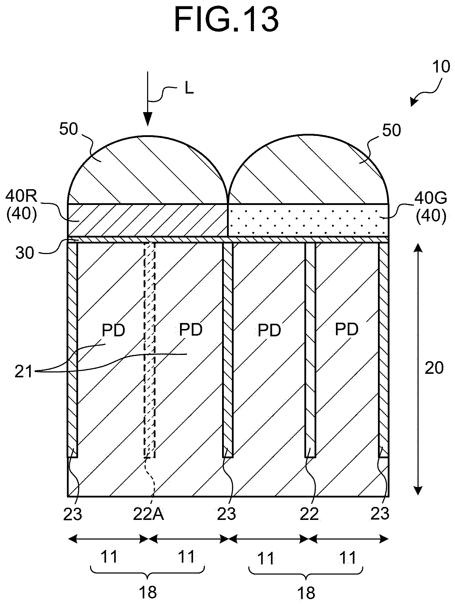

FIG. 13 is an enlarged cross-sectional view illustrating a cross-sectional structure of the pixel array unit 10 according to a sixth modification of the embodiment of the present disclosure. In such a sixth modification, a first separation region 22A that separates the plurality of photodiodes 21 on which the light L is incident through the red filter 40R is separated by an ion implantation region instead of a dielectric. In other words, the first separation region 22A of the pixel group 18 including the red filter 40R is separated by the ion implantation region rather than the dielectric.

That is, the first separation region 22A is made of the same material as the semiconductor layer 20 (for example, silicon) and has the same refractive index as the semiconductor layer 20. Note that, in the sixth modification, the first separation regions 22 of the pixel groups 18 including the green filter 40G and the blue filter 40B are made of a dielectric having a high refractive index (for example, tantalum oxide or titanium oxide) similarly to the embodiment.

As a result, it is unnecessary to form a trench in the semiconductor layer 20 when forming the first separation region 22A, and thus, the manufacturing cost of the pixel array unit 10 can be reduced.

Note that the detection accuracy of a phase difference in the pixel group 18 including the red filter 40R is lower than that in the pixel groups 18 of other colors since a wavelength of the incident light L is long. Therefore, it is possible to realize the phase difference detection accuracy equivalent to that of the embodiment by preferentially utilizing the pixel groups 18 of other colors to detect the phase difference.

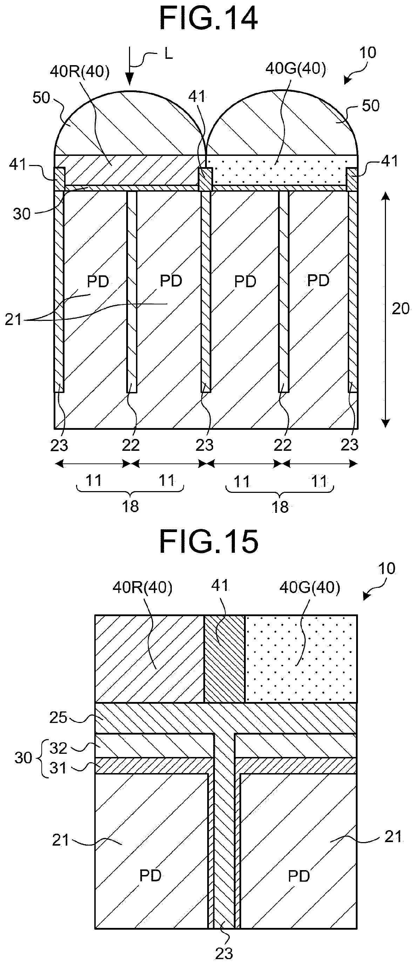

FIG. 14 is an enlarged cross-sectional view illustrating a cross-sectional structure of the pixel array unit 10 according to a seventh modification of the embodiment of the present disclosure. In the seventh modification, a structure of the color filter 40 is different from that of the embodiment.

Specifically, an inter-pixel light-shielding film 41 is provided between adjacent color filters 40 of different colors. The inter-pixel light-shielding film 41 is made of a material that blocks the light L. As the material used for the inter-pixel light-shielding film 41, it is desirable to use the material that has a strong light-shielding property and can be processed with high accuracy by microfabrication, for example, etching.

The inter-pixel light-shielding film 41 can be formed using, for example, a metal film such as tungsten (W), aluminum (Al), copper (Cu), titanium (Ti), molybdenum (Mo), and nickel (Ni).

In the seventh modification, it is possible to suppress the light L, obliquely incident on the color filter 40 having a color different from that of the color filter 40 corresponding to the unit pixel 11, from being incident on the unit pixel 11 by providing the inter-pixel light-shielding film 41.

Therefore, it is possible to suppress the occurrence of color mixing due to the light L obliquely incident on the color filter 40 according to the seventh modification.

Note that the example in which the inter-pixel light-shielding film 41 is provided so as to be in contact with a surface of the semiconductor layer 20 on the light incident side has been illustrated in the example of FIG. 14, but an arrangement of the inter-pixel light-shielding film 41 is not limited to such an example. FIG. 15 is an enlarged cross-sectional view illustrating a cross-sectional structure of the pixel array unit 10 according to an eighth modification of the embodiment of the present disclosure.

As illustrated in FIG. 15, the inter-pixel light-shielding film 41 may be provided so as to be in contact with a surface of the silicon oxide film 25 on the light incident side illustrated in the first modification. Even in the eighth modification configured as above, it is possible to suppress the occurrence of color mixing due to the light L obliquely incident on the color filter 40 similarly to the seventh modification.

Note that the inter-pixel light-shielding film 41 may be provided so as to be in contact with a surface of the fixed charge film 30 on the light incident side.

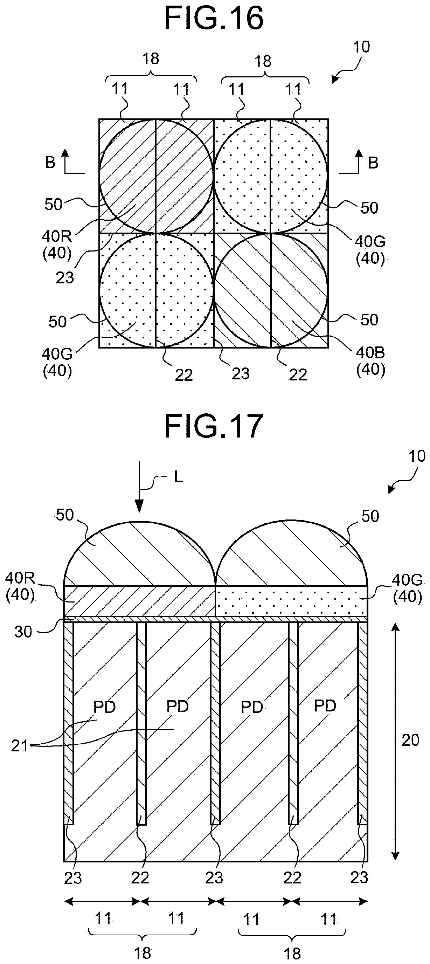

FIG. 16 is a plan view for describing an arrangement of the unit pixel 11, the color filter 40, and the on-chip lens 50 of the pixel array unit 10 according to a ninth modification of the embodiment of the present disclosure, and FIG. 17 is a cross-sectional view taken along line B-B illustrated in FIG. 16.

As illustrated in FIG. 16, one pixel group 18 is formed of a pair of the unit pixels 11 adjacent to each other in the left-right direction in the pixel array unit 10 according to the ninth modification. Then, one on-chip lens 50 and any one of the red filter 40R, the green filter 40G, and the blue filter 40B are provided for each pixel group 18.

In the ninth modification, a phase difference can be detected by sharing the same on-chip lens 50 and color filter 40 between the pair of unit pixels 11 adjacent to each other in the left-right direction. Therefore, the solid-state imaging device 1 can be provided with an autofocus function of a phase difference detection system according to the ninth modification.

Then, the plurality of photodiodes 21 on which the light L is incident through the same on-chip lens 50 are separated by the first separation region 22, and the plurality of photodiodes 21 on which light L is incident through different on-chip lenses 50 are separated by the second separation region 23, in the ninth modification.

As a result, it is possible to suppress the occurrence of color mixing in the pair of unit pixels 11 that share the same on-chip lens 50 and color filter 40. Therefore, the autofocus accuracy of the phase difference detection system in the solid-state imaging device 1 can be improved according to the ninth modification.

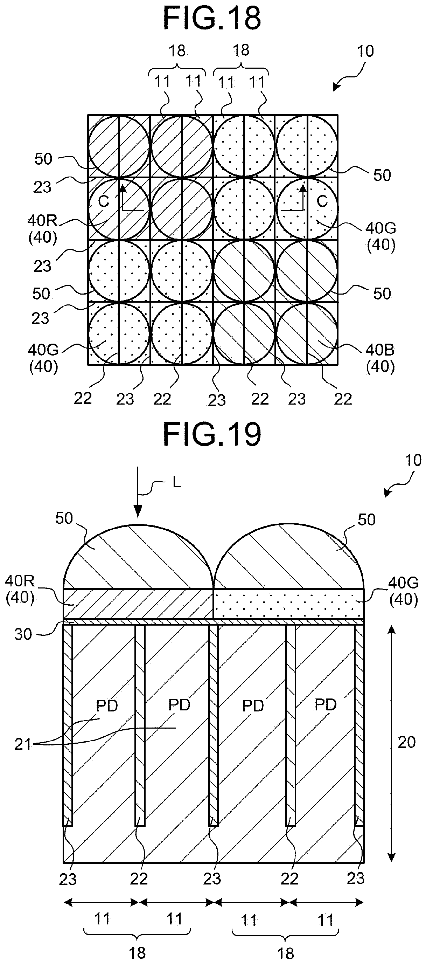

FIG. 18 is a plan view for describing an arrangement of the unit pixel 11, the color filter 40, and the on-chip lens 50 of the pixel array unit 10 according to a tenth modification of the embodiment of the present disclosure, and FIG. 19 is a cross-sectional view taken along line C-C illustrated in FIG. 18.

As illustrated in FIG. 18, one pixel group 18 is formed of a pair of the unit pixels 11 adjacent to each other in the left-right direction in the pixel array unit 10 according to the tenth modification. In addition, one on-chip lens 50 is provided for each pixel group 18. Then, any one of the red filter 40R, the green filter 40G, and the blue filter 40B is provided for each of the plurality of pixel groups 18 (in two rows and two columns in FIG. 18).

In the tenth modification, a phase difference can be detected by sharing the same on-chip lens 50 and color filter 40 between the pair of unit pixels 11 adjacent to each other in the left-right direction. Therefore, the solid-state imaging device 1 can be provided with an autofocus function of a phase difference detection system according to the tenth modification.

Then, the plurality of photodiodes 21 on which the light L is incident through the same on-chip lens 50 are separated by the first separation region 22, and the plurality of photodiodes 21 on which light L is incident through different on-chip lenses 50 are separated by the second separation region 23, in the tenth modification.

As a result, it is possible to suppress the occurrence of color mixing in the pair of unit pixels 11 that share the same on-chip lens 50 and color filter 40. Therefore, the autofocus accuracy of the phase difference detection system in the solid-state imaging device 1 can be improved according to the tenth modification.

In addition, the solid-state imaging device 1 can be provided with an HDR function and a remosaic function by sharing the same color filter 40 among the plurality of unit pixels 11 according to the tenth modification.

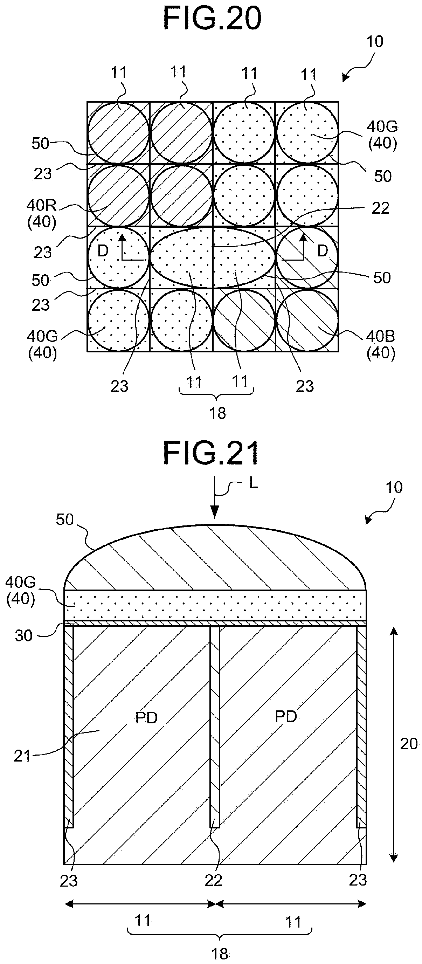

FIG. 20 is a plan view for describing an arrangement of the unit pixel 11, the color filter 40, and the on-chip lens 50 of the pixel array unit 10 according to an eleventh modification of the embodiment of the present disclosure, and FIG. 21 is a cross-sectional view taken along line D-D illustrated in FIG. 20.

As illustrated in FIG. 20, the pixel array unit 10 according to the eleventh modification includes the pixel group 18 having a pair of the unit pixels 11 adjacent to each other in the left-right direction. In addition, the pixel group 18 shares the same on-chip lens 50 and green filter 40G, and thus, the solid-state imaging device 1 according to the eleventh modification can detect a phase difference.

Then, the plurality of photodiodes 21 on which the light L is incident through the same on-chip lens 50 are separated by the first separation region 22, and the plurality of photodiodes 21 on which light L is incident through different on-chip lenses 50 are separated by the second separation region 23, in the eleventh modification.

As a result, it is possible to suppress the occurrence of color mixing in the pair of unit pixels 11 that share the same on-chip lens 50 and green filter 40G. Therefore, the autofocus accuracy of the phase difference detection system in the solid-state imaging device 1 can be improved according to the eleventh modification.

In addition, the same color filter 40 is shared by the plurality of unit pixels 11 in the eleventh modification as illustrated in FIG. 20, and thus, the solid-state imaging device 1 can be provided with an HDR function and a remosaic function.

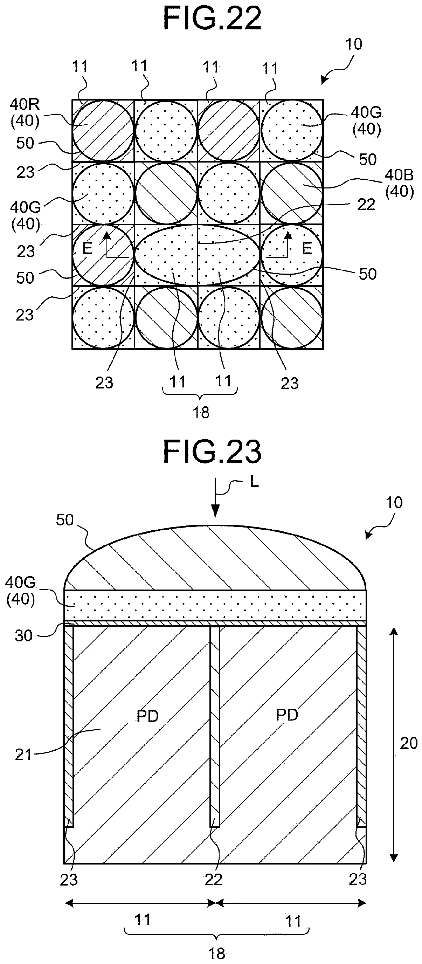

FIG. 22 is a plan view for describing an arrangement of the unit pixel 11, the color filter 40, and the on-chip lens 50 of the pixel array unit 10 according to a twelfth modification of the embodiment of the present disclosure, and FIG. 23 is a cross-sectional view taken along line E-E illustrated in FIG. 22.

As illustrated in FIG. 22, the pixel array unit 10 according to the twelfth modification includes the pixel group 18 having a pair of the unit pixels 11 adjacent to each other in the left-right direction. In addition, the pixel group 18 shares the same on-chip lens 50 and green filter 40G, and thus, the solid-state imaging device 1 according to the twelfth modification can detect a phase difference.

Then, the plurality of photodiodes 21 on which the light L is incident through the same on-chip lens 50 are separated by the first separation region 22, and the plurality of photodiodes 21 on which light L is incident through different on-chip lenses 50 are separated by the second separation region 23, in the twelfth modification.

As a result, it is possible to suppress the occurrence of color mixing in the pair of unit pixels 11 that share the same on-chip lens 50 and green filter 40G. Therefore, the autofocus accuracy of a phase difference detection system in the solid-state imaging device 1 can be improved according to the twelfth modification.

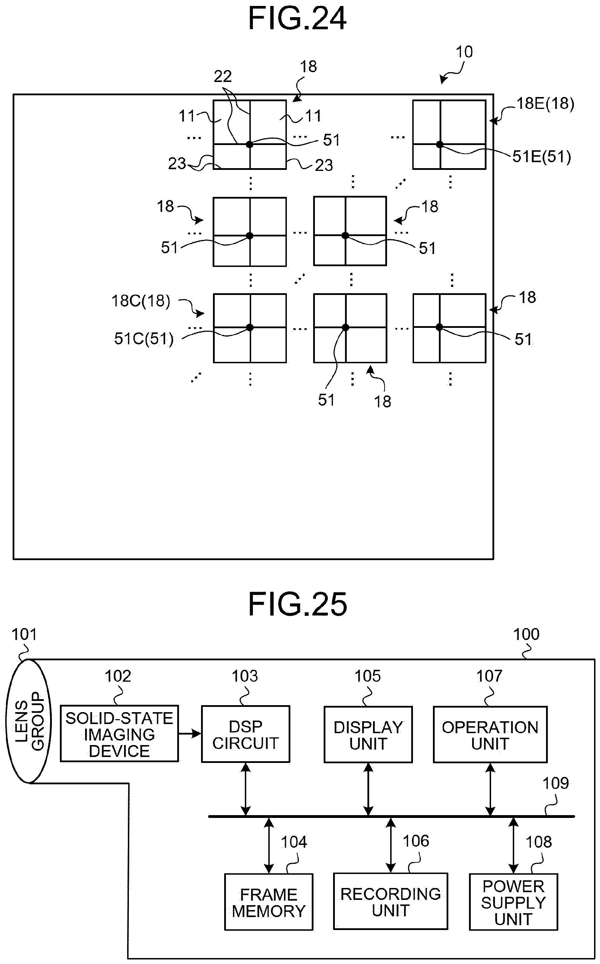

FIG. 24 is a plan view for describing an arrangement of the pixel group 18 and a light collection point 51 of the pixel array unit 10 according to a thirteenth modification of the embodiment of the present disclosure. Note that a large number of the pixel groups 18 constituted by the unit pixels 11 in two rows and two columns are arranged in a matrix, and one on-chip lens 50 (see FIG. 2) is provided for each of the pixel groups 18, in the thirteenth modification.

In the pixel array unit 10 having a large number of pixel groups 18, an incident angle of the light L (see FIG. 3) from the on-chip lens 50 is different between a pixel group 18C located at the center of the angle of view and the pixel group 18 located at an end of the angle of view (for example, a pixel group 18E at a corner). As a result, light is not sufficiently incident on the pixel 11 so that a pixel signal deteriorates in the pixel group 18 at the end.

Therefore, a position of the first separation region 22 is changed according to a position of the pixel group 18 on the pixel array unit 10 in the thirteenth modification. Specifically, the first separation regions 22 are arranged in each of the pixel groups 18 such that the light collection point 51 of the on-chip lens 50 coincides with an intersection between the first separation regions 22 intersecting each other in a cross shape.

For example, a light collection point 51C is the center of the pixel group 18 in the pixel group 18C located at the center of the angle of view, and thus, the first separation regions 22 are arranged such that an intersection between the first separation regions 22 is the center of the pixel group 18.

In addition, when a light collection point 51E shifts from the center of the pixel group 18 toward the center side of the pixel array unit 10 in the pixel group 18E located at the corner of the angle of view, the first separation regions 22 are arranged so as to shift an intersection between the first separation regions 22 in the same manner.

Since a position of the intersection between the first separation regions 22 is appropriately adjusted for each of the pixel groups 18 in this manner, a difference in the pixel signal generated according to the position on the pixel array unit 10 of the pixel group 18 can be suppressed in the thirteenth modification.

Note that the case where the light collection point 51E shifts from the center of the pixel group 18 toward the center side of the pixel array unit 10 in the pixel group 18E located at the corner of the angle of view has been illustrated in the example of FIG. 24. However, a direction in which the light collection point 51E shifts is not limited to the center side of the pixel array unit 10, and the light collection point 51E may shift to a side away from the center of the pixel array unit 10, for example.

### [Effects]

The solid-state imaging device 1 according to the embodiment includes the semiconductor layer 20, the plurality of on-chip lenses 50, the first separation region 22, and the second separation region 23. The semiconductor layer 20 is provided with the plurality of photoelectric conversion units (photodiodes 21). The plurality of on-chip lenses 50 cause the light L to be incident on the corresponding photoelectric conversion units (photodiodes 21). The first separation region 22 separates the plurality of photoelectric conversion units (photodiodes 21) on which the light L is incident through the same on-chip lens 50. The second separation region 23 separates the plurality of photoelectric conversion units (photodiodes 21) on which the light L is incident through the different on-chip lenses 50. In addition, the first separation region 22 has the higher refractive index than the second separation region 23.

As a result, it is possible to realize the solid-state imaging device 1 capable of suppressing the occurrence of color mixing.

In addition, the solid-state imaging device 1 according to the embodiment includes the color filters 40 of the plurality of colors provided between the semiconductor layer 20 and the on-chip lenses 50. In addition, the first separation region 22 separates the plurality of photoelectric conversion units (photodiodes 21) on which the light L is incident through the color filter 40 of the same color. In addition, the second separation region 23 separates the plurality of photoelectric conversion units (photodiodes 21) on which the light L is incident through the color filters 40 of different colors.

As a result, the autofocus accuracy of the phase difference detection system in the solid-state imaging device 1 can be improved.

In addition, the first separation region 22A that separates the plurality of photoelectric conversion units (photodiodes 21) on which the light L is incident through the red color filter 40 (red filter 40R) has the refractive index equal to that of the semiconductor layer 20 in the solid-state imaging device 1 according to the embodiment.

As a result, the manufacturing cost of the pixel array unit 10 can be reduced.

In addition, the first separation region 22 and the second separation region 23 do not penetrate the semiconductor layer 20 in the solid-state imaging device 1 according to the embodiment.

As a result, the manufacturing cost of the pixel array unit 10 can be reduced.

In addition, the first separation region 22 does not penetrate the semiconductor layer 20, and the second separation region 23 penetrates the semiconductor layer 20 in the solid-state imaging device 1 according to the embodiment.

As a result, the occurrence of color mixing can be further suppressed.

In addition, the first separation region 22 and the second separation region 23 penetrate the semiconductor layer 20 in the solid-state imaging device 1 according to the embodiment.

As a result, the occurrence of color mixing can be further suppressed.

In addition, the refractive index of the first separation region 22 at the wavelength of 530 nm is 2.0 or more and less than 4.2 in the solid-state imaging device 1 according to the embodiment.

As a result, the occurrence of color mixing due to scattered light can be further suppressed.

In addition, the refractive index of the second separation region 23 at the wavelength of 530 nm is 1.0 or more and 1.5 or less in the solid-state imaging device 1 according to the embodiment.

As a result, it is possible to further suppress the occurrence of color mixing due to the light L incident on the photodiode 21.

In addition, the first separation region 22 contains the same material as the fixed charge film 30 (second fixed charge film 32) in the solid-state imaging device 1 according to the embodiment.

As a result, the manufacturing cost of the pixel array unit 10 can be reduced.

In addition, the end 22a of the first separation region 22 on the light incident side has the higher refractive index than the second separation region 23, and the portion 22b of the first separation region 22 other than the end 22a on the light incident side has the smaller refractive index than the end 22a on the light incident side, in the solid-state imaging device 1 according to the embodiment.

As a result, both the occurrence of color mixing due to the scattered light and the occurrence of color mixing due to the light L incident on the photodiode 21 can be suppressed in the first separation region 22.

In addition, the depth of the end 22a of the first separation region 22 on the light incident side is 20 nm or more and 100 nm or less in the solid-state imaging device 1 according to the embodiment.

As a result, both the occurrence of color mixing due to the scattered light and the occurrence of color mixing due to the light L incident on the photodiode 21 can be suppressed in a well-balanced manner in the first separation region 22.

In addition, the first separation region 22 has the smaller thickness than the second separation region 23 in the solid-state imaging device 1 according to the embodiment.

As a result, the occurrence of color mixing due to scattered light can be further suppressed.

### [Electronic Device]

Note that the present disclosure is not limited to the application to the solid-state imaging device. That is, the present disclosure can be applied to a camera module, an imaging device, a mobile terminal device having an imaging function or all electronic devices having a solid-state imaging device, such as a copier that uses the solid-state imaging device as an image reading unit, in addition to the solid-state imaging device.

Examples of such an imaging device include a digital still camera and a video camera. In addition, examples of such a mobile terminal device having the imaging function include a smartphone and a tablet terminal.

FIG. 25 is a block diagram illustrating a configuration example of an imaging device as an electronic device 100 to which the technology according to the present disclosure is applied. The electronic device 100 of FIG. 25 is, for example, an electronic device such as an imaging device such as a digital still camera and a video camera, and a mobile terminal device such as a smartphone and a tablet terminal.

In FIG. 25, the electronic device 100 includes a lens group 101, a solid-state imaging device 102, a DSP circuit 103, a frame memory 104, a display unit 105, a recording unit 106, an operation unit 107, and a power supply unit 108.

In addition, the DSP circuit 103, the frame memory 104, the display unit 105, the recording unit 106, the operation unit 107, and the power supply unit 108 in the electronic device 100 are connected to each other via a bus line 109.

The lens group 101 captures incident light (image light) from the subject and forms an image on an imaging surface of the solid-state imaging device 102. The solid-state imaging device 102 corresponds to the solid-state imaging device 1 according to the above-described embodiment, and converts the amount of incident light imaged on the imaging surface by the lens group 101 into an electrical signal in units of pixels and outputs the electrical signal as a pixel signal.

The DSP circuit 103 is a camera signal processing circuit that processes a signal supplied from the solid-state imaging device 102. The frame memory 104 temporarily holds image data processed by the DSP circuit 103 in units of frames.

The display unit 105 is configured using a panel-type display device such as a liquid crystal panel and an organic electro luminescence (EL) panel, and displays a moving image or a still image captured by the solid-state imaging device 102. The recording unit 106 records image data of the moving image or the still image captured by the solid-state imaging device 102 on a recording medium such as a semiconductor memory and a hard disk.

The operation unit 107 issues operation commands for various functions of the electronic device 100 according to user's operations. The power supply unit 108 appropriately supplies various power sources that serve as operating power sources for the DSP circuit 103, the frame memory 104, the display unit 105, the recording unit 106, and the operation unit 107 to these supply targets.

In the electronic device 100 configured in this manner, the occurrence of color mixing can be suppressed by applying the solid-state imaging device 1 of each of the above-described embodiments as the solid-state imaging device 102.

### [Application Example to Moving Object]

The technology according to the present disclosure (the present technology) can be applied to various products. For example, the technology according to the present disclosure may be implemented as a device mounted on a moving object of any type such as a vehicle, an electric vehicle, a hybrid electric vehicle, a motorcycle, a bicycle, a personal mobility, an airplane, a drone, a ship, and a robot.

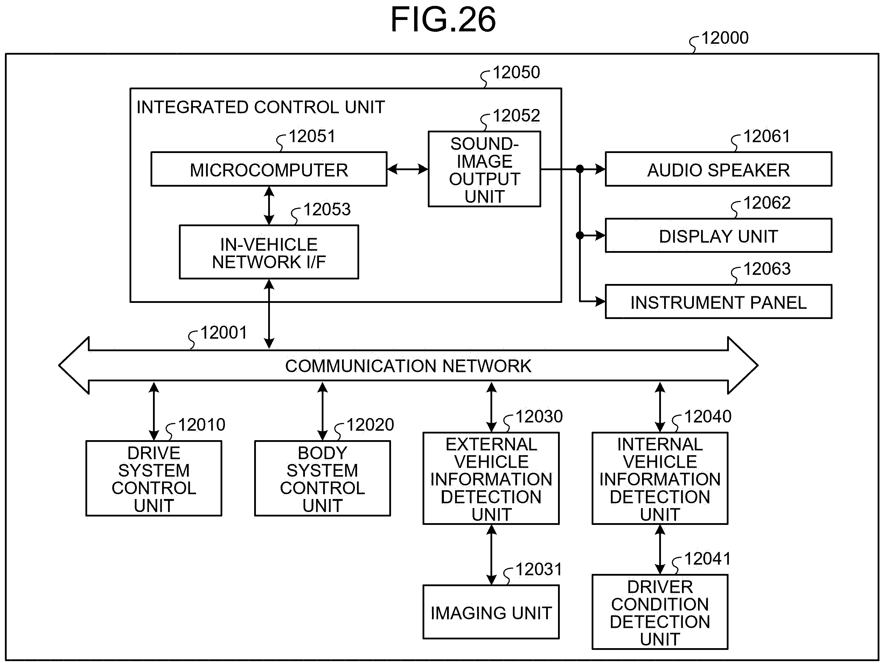

FIG. 26 is a block diagram illustrating a schematic configuration example of a vehicle control system, which is an example of a moving object control system to which the technology according to the present disclosure can be applied.

A vehicle control system 12000 includes a plurality of electronic control units connected via a communication network 12001. In the example illustrated in FIG. 26, the vehicle control system 12000 includes a drive system control unit 12010, a body system control unit 12020, an external vehicle information detection unit 12030, an internal vehicle information detection unit 12040, and an integrated control unit 12050. In addition, as a functional configuration of the integrated control unit 12050, a microcomputer 12051, a sound-image output unit 12052, and an in-vehicle network interface (I/F) 12053 are illustrated.

The drive system control unit 12010 controls operations of devices related to a drive system of a vehicle according to various programs. For example, the drive system control unit 12010 functions as a control device of a driving force generation device, such as an internal combustion engine and a driving motor, configured to generate a driving force of the vehicle, a driving force transmitting mechanism configured to transmit the driving force to wheels, a steering mechanism that adjusts a steering angle of the vehicle, a braking device that generates a braking force of the vehicle, and the like.

The body system control unit 12020 controls operations of various devices mounted on a vehicle body according to various programs. For example, the body system control unit 12020 functions as a control device of a keyless entry system, a smart key system, a power window device, or various lamps such as a head lamp, a back lamp, a brake lamp, a turn signal, and a fog lamp. In this case, the body system control unit 12020 can receive input of radio waves transmitted from a portable device substituted for a key or signals of various switches. The body system control unit 12020 receives input of these radio waves or signals to control a door lock device, the power window device, the lamps, or the like of the vehicle.

The external vehicle information detection unit 12030 detects information regarding the outside of the vehicle on which the vehicle control system 12000 is mounted. For example, an imaging unit 12031 is connected to the external vehicle information detection unit 12030. The external vehicle information detection unit 12030 causes the imaging unit 12031 to capture an image of the outside of the vehicle and receives the captured image. The external vehicle information detection unit 12030 may perform object detection processing or distance detection processing of a person, a car, an obstacle, a sign, a character on a road surface, or the like based on the received image.

The imaging unit 12031 is an optical sensor that receives light and outputs an electrical signal according to the amount of the received light. The imaging unit 12031 can output the electrical signal as an image and also as ranging information. In addition, the light received by the imaging unit 12031 may be visible light or invisible light such as infrared light.

The internal vehicle information detection unit 12040 detects internal vehicle information. The internal vehicle information detection unit 12040 is connected with a driver condition detection unit 12041 that detects a condition of a driver, for example. The driver condition detection unit 12041 includes a camera that images the driver, for example, and the internal vehicle information detection unit 12040 may calculate a degree of fatigue or degree of concentration of the driver or may determine whether the driver is dozing off based on detection information input from the driver condition detection unit 12041.

The microcomputer 12051 can calculate a control target value of the driving force generation device, the steering mechanism, or the braking device based on the information regarding the inside or outside of the vehicle acquired by the external vehicle information detection unit 12030 or the internal vehicle information detection unit 12040, and output a control command to the drive system control unit 12010. For example, the microcomputer 12051 can perform cooperative control for the purpose of implementing a function of an advanced driver assistance system (ADAS) including collision avoidance or impact mitigation for the vehicle, travel following a vehicle ahead based on an inter-vehicle distance, constant speed travel, a vehicle collision warning, or a warning for the vehicle deviating a lane.

In addition, the microcomputer 12051 can perform cooperative control for the purpose of automated driving or the like with which the vehicle travels autonomously without depending on the driver's operation by controlling the driving force generation device, the steering mechanism, the braking device, or the like based on information regarding the surroundings of the vehicle acquired by the external vehicle information detection unit 12030 or the internal vehicle information detection unit 12040.

In addition, the microcomputer 12051 can output a control command to the body system control unit 12020 based on the information regarding the outside of the vehicle acquired by the external vehicle information detection unit 12030. For example, the microcomputer 12051 can perform cooperative control for the purpose of anti-glare such as switching from a high beam to a low beam by controlling a head lamp depending on a position of a vehicle ahead or an oncoming vehicle detected by the external vehicle information detection unit 12030.

The sound-image output unit 12052 transmits an output signal of at least one of a sound or an image to an output device that can visually or aurally provide notification of information to a passenger of the vehicle or the outside of the vehicle. In the example of FIG. 26, an audio speaker 12061, a display unit 12062, and an instrument panel 12063 are exemplified as the output device. The display unit 12062 may include at least one of an on-board display and a head-up display, for example.

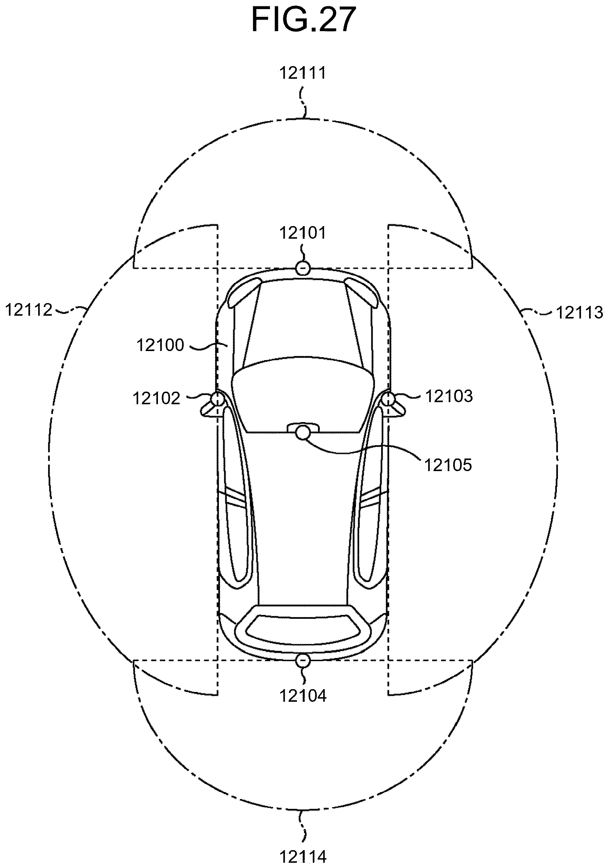

FIG. 27 is a view illustrating an example of an installation position of the imaging unit 12031.

In FIG. 27, imaging units 12101, 12102, 12103, 12104, and 12105 are provided as the imaging unit 12031.

The imaging units 12101, 12102, 12103, 12104, and 12105 are installed at positions such as a front nose, side mirrors, a rear bumper, a back door, and an upper part of a windshield in a passenger compartment of a vehicle 12100, for example. The imaging unit 12101 installed at the front nose and the imaging unit 12105 installed in the upper part of the windshield in the passenger compartment mainly acquire an image of an area in front of the vehicle 12100. The imaging units 12102 and 12103 installed on the side mirrors mainly acquire images of the sides of the vehicle 12100. The imaging unit 12104 installed on the rear bumper or the back door mainly acquires an image of an area behind the vehicle 12100. The imaging unit 12105 provided in the upper part of the windshield in the passenger compartment is mainly used to detect a preceding vehicle or a pedestrian, an obstacle, a traffic light, a traffic sign, a lane, or the like.

Note that FIG. 27 illustrates an example of capturing ranges of the imaging units 12101 to 12104. An imaging range 12111 indicates an imaging range of the imaging unit 12101 provided on the front nose, imaging ranges 12112 and 12113 indicate imaging ranges of the imaging units 12102 and 12103 provided on the side mirrors, respectively, and an imaging range 12114 indicates an imaging range of the imaging unit 12104 provided on the rear bumper or the back door. For example, a bird's-eye view image of the vehicle 12100 viewed from above can be obtained by superimposing image data captured by the imaging units 12101 to 12104.

At least one of the imaging units 12101 to 12104 may have a function of acquiring distance information. For example, at least one of the imaging units 12101 to 12104 may be a stereo camera including a plurality of imaging elements, or may be an imaging element having pixels for phase difference detection.

For example, the microcomputer 12051 obtains a distance to each three-dimensional object within the imaging ranges 12111 to 12114 and a temporal change in the distance (relative speed with respect to the vehicle 12100) based on the distance information obtained from the imaging units 12101 to 12104, and thus, can particularly extract, as a vehicle ahead, a three-dimensional object closest on a path of travel of the vehicle 12100 and traveling at a predetermined speed (for example, 0 km/h or faster) in substantially the same direction as that of the vehicle 12100. In addition, the microcomputer 12051 can set an inter-vehicle distance to be secured in advance behind the vehicle ahead, and perform automatic brake control (including follow-up stop control), automatic acceleration control (including follow-up start control), and the like. In this manner, it is possible to perform the cooperative control for the purpose of automated driving or the like for autonomous traveling without depending on the driver's operation.

For example, the microcomputer 12051 classifies three-dimensional object data relating to a three-dimensional object into a two-wheeled vehicle, a standard sized vehicle, a large sized vehicle, a pedestrian, and other three-dimensional objects such as a utility pole, and extracts the data for use in automatic avoidance of an obstacle on the basis of the distance information obtained from the imaging units 12101 to 12104. For example, the microcomputer 12051 distinguishes obstacles in the vicinity of the vehicle 12100 as an obstacle that can be visually recognized by the driver of the vehicle 12100 or an obstacle that is difficult to be visually recognized by the driver. Then, the microcomputer 12051 determines a risk of collision indicating the degree of risk of collision with each obstacle, and can perform driver assistance to avoid collision in a situation where there is a possibility of collision with the risk of collision equal to or higher than a set value by outputting an alarm to the driver via the audio speaker 12061 and/or the display unit 12062 or performing forced deceleration or evasive steering via the drive system control unit 12010.

At least one of the imaging units 12101 to 12104 may be an infrared camera that detects infrared light. For example, the microcomputer 12051 can recognize a pedestrian by determining whether the pedestrian is present in images captured by the imaging units 12101 to 12104. Such pedestrian recognition is performed by a procedure of extracting feature points in the images captured by the imaging units 12101 to 12104, which are infrared cameras, for example, and a procedure of performing pattern matching on a series of feature points indicating an outline of an object and determining whether the object corresponds to the pedestrian. When the microcomputer 12051 determines that the pedestrian is present in the images captured by the imaging units 12101 to 12104 and recognizes the pedestrian, the sound-image output unit 12052 controls the display unit 12062 such that a rectangular contour for emphasis is superimposed and displayed on the recognized pedestrian. In addition, the sound-image output unit 12052 may also control the display unit 12062 to display an icon or the like indicating the pedestrian at a desired position.

An example of the vehicle control system to which the technology according to the present disclosure can be applied has been described above. The technology according to the present disclosure can be applied to the imaging unit 12031 and the like among the configurations described above. Specifically, the solid-state imaging device 1 of FIG. 1 can be applied to the imaging unit 12031. Since the technology according to the present disclosure is applied to the imaging unit 12031, it is possible to suppress the occurrence of color mixing in the imaging unit 12031.

### [Application Example to Endoscopic Surgery System]

The technology according to the present disclosure (the present technology) can be applied to various products. For example, the technology according to the present disclosure may be applied to an endoscopic surgery system.

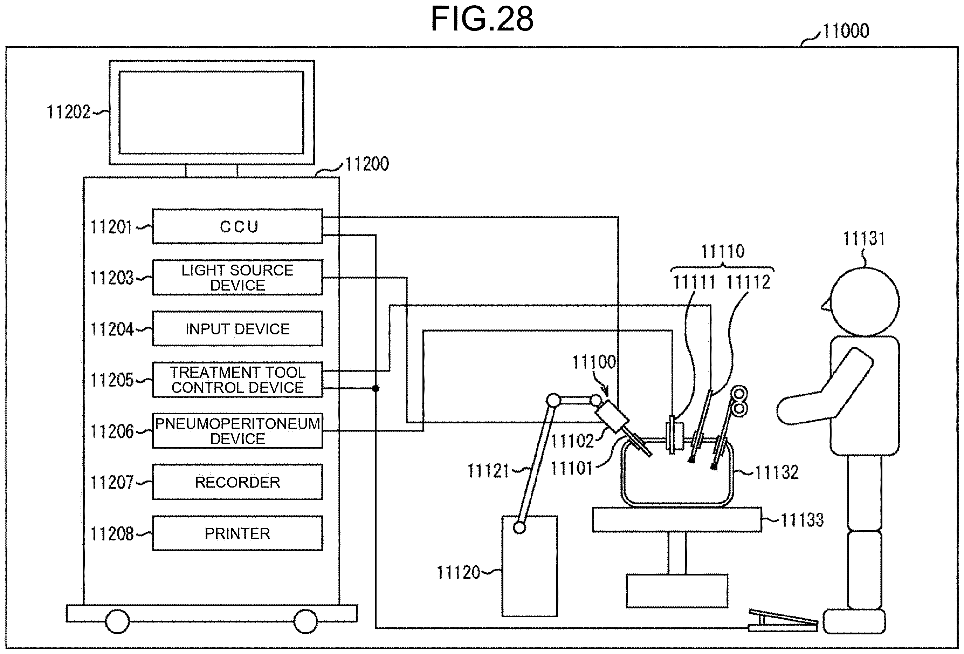

FIG. 28 is a diagram illustrating an example of a schematic configuration of the endoscopic surgery system to which the technology according to the present disclosure (the present technology) can be applied.

FIG. 28 illustrates a state where a surgeon (doctor) 11131 performs surgery on a patient 11132 on a patient bed 11133 using an endoscopic surgery system 11000. As illustrated, the endoscopic surgery system 11000 includes an endoscope 11100, other surgical tools 11110, such as a pneumoperitoneum tube 11111 and an energy treatment tool 11112, a support arm device 11120 that supports the endoscope 11100, and a cart 11200 equipped with various devices for endoscopic surgery.

The endoscope 11100 includes a lens barrel 11101 in which a region having a predetermined length from a distal end is inserted into a body cavity of the patient 11132 and a camera head 11102 connected to a proximal end of the lens barrel 11101. In the illustrated example, the endoscope 11100 configured as a so-called rigid mirror having the rigid lens barrel 11101 is illustrated, but the endoscope 11100 may be configured as a so-called flexible mirror having a flexible lens barrel.

The distal end of the lens barrel 11101 is provided with an opening in which an objective lens has been fitted. A light source device 11203 is connected to the endoscope 11100, and light generated by the light source device 11203 is guided to the distal end of the lens barrel by a light guide extending inside the lens barrel 11101 and is emitted toward an observation target in the body cavity of the patient 11132 through the objective lens. Note that the endoscope 11100 may be a direct-viewing endoscope, or may be an oblique-viewing endoscope or a side-viewing endoscope.

An optical system and an imaging element are provided inside the camera head 11102, and light (observation light) reflected from the observation target is collected on the imaging element by the optical system. The observation light is photoelectrically converted by the imaging element so that an electrical signal corresponding to the observation light, that is, an image signal corresponding to an observation image is generated. The image signal is transmitted to a camera control unit (CCU) 11201 as RAW data.

The CCU 11201 is configured using a central processing unit (CPU), a graphics processing unit (GPU), or the like, and integrally controls the operations of the endoscope 11100 and a display device 11202. In addition, the CCU 11201 receives an image signal from the camera head 11102 and performs various types of image processing to display an image based on the image signal, such as development processing (demosaic processing), on the image signal.

The display device 11202 displays an image based on the image signal processed by the CCU 11201 under the control of the CCU 11201.

The light source device 11203 is configured using, for example, a light source such as a light emitting diode (LED), and supplies irradiation light at the time of capturing a surgical site or the like to the endoscope 11100.

An input device 11204 is an input interface with respect to the endoscopic surgery system 11000. A user can input various types of information and input instructions to the endoscopic surgery system 11000 via the input device 11204. For example, the user inputs an instruction to change an imaging condition (a type of irradiation light, a magnification, a focal length, or the like) of the endoscope 11100.

A treatment tool control device 11205 controls driving of the energy treatment tool 11112 configured for ablation of a tissue, incision, sealing of a blood vessel, and the like. A pneumoperitoneum device 11206 delivers a gas into the body cavity through the pneumoperitoneum tube 11111 to inflate the body cavity of the patient 11132 for the purpose of securing the field of view for the endoscope 11100 and securing a work space of the surgeon. A recorder 11207 is a device that can record various types of information related to surgery. A printer 11208 is a device capable of printing various types of information related to surgery in various formats such as text, an image, and a graph.

Note that the light source device 11203 that supplies the irradiation light to the endoscope 11100 at the time of capturing the surgical site can be configured using, for example, an LED, a laser light source, or a white light source configured by a combination thereof. When the white light source is configured by a combination of RGB laser light source, the output intensity and output timing of each color (each wavelength) can be controlled with high accuracy, and thus, the white balance of a captured image can be adjusted by the light source device 11203. In addition, in this case, an observation target is irradiated with laser light from each of the RGB laser light sources in a time-division manner, and driving of the imaging element of the camera head 11102 is controlled in synchronization with the irradiation timing, so that it is also possible to capture images corresponding to R, G, and B in a time-division manner. According to this method, a color image can be obtained without providing a color filter on the imaging element.

In addition, the driving of the light source device 11203 may be controlled so as to change the intensity of output light at predetermined time intervals. When images are acquired in a time-division manner by controlling the driving of the imaging element of the camera head 11102 in synchronization with the timing of the change of the light intensity and the images are combined, it is possible to generate an image having a high dynamic range without so-called blackout and whiteout.

In addition, the light source device 11203 may be configured to be capable of supplying light in a predetermined wavelength band corresponding to special light observation. The special light observation performs so-called narrow band imaging that captures a predetermined tissue, such as a blood vessel in a mucosal surface layer, with high contrast by using, for example, the wavelength dependence of light absorption in a body tissue and emitting light in a narrower band than irradiation light (that is, white light) at the time of normal observation. Alternatively, the special light observation may perform fluorescence observation that obtains an image by fluorescence generated by emitting excitation light. The fluorescence observation can observe fluorescence from a body tissue by emitting the excitation light to the body tissue (autofluorescence observation), or obtain a fluorescent image by performing local injection of a reagent such as indocyanine green (ICG) into a body tissue and emitting excitation light corresponding to a fluorescence wavelength of the reagent to the body tissue. The light source device 11203 may be configured to be capable of supplying narrowband light and/or excitation light compatible with such special light observation.

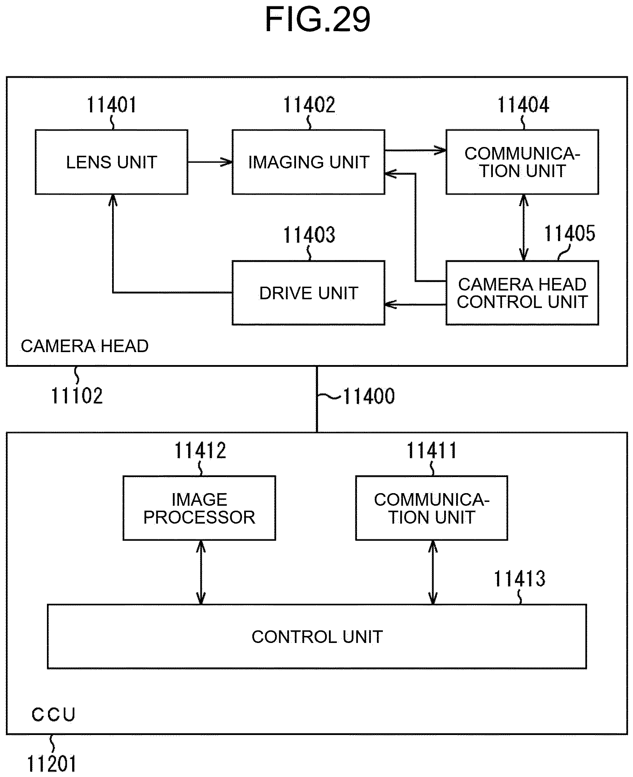

FIG. 29 is a block diagram illustrating an example of functional configurations of the camera head 11102 and the CCU 11201 illustrated in FIG. 28.

The camera head 11102 includes a lens unit 11401, an imaging unit 11402, a drive unit 11403, a communication unit 11404, and a camera head control unit 11405. The CCU 11201 has a communication unit 11411, an image processor 11412, and a control unit 11413. The camera head 11102 and the CCU 11201 are connected via a transmission cable 11400 to be capable of performing communication with each other.

The lens unit 11401 is an optical system provided at a connection portion with the lens barrel 11101. Observation light taken in from the distal end of the lens barrel 11101 is guided to the camera head 11102 and incident on the lens unit 11401. The lens unit 11401 is configured by combining a plurality of lenses including a zoom lens and a focus lens.

The imaging element forming the imaging unit 11402 may be one (a so-called single plate type) or plural (a so-called multi-plate type) in number. When the imaging unit 11402 is of the multi-plate type, for example, image signals corresponding to R, G, and B may be generated by the respective imaging elements and combined to obtain a color image. Alternatively, the imaging unit 11402 may include a pair of imaging elements configured to acquire right-eye and left-eye image signals compatible with three-dimensional (3D) display. The 3D display enables the surgeon 11131 to more accurately grasp the depth of a living tissue in a surgical site. Note that a plurality of the lens units 11401 corresponding to the imaging elements can be provided when the imaging unit 11402 is of the multi-plate type.

In addition, the imaging unit 11402 is not necessarily provided on the camera head 11102. For example, the imaging unit 11402 may be provided inside the lens barrel 11101 immediately behind the objective lens.

The drive unit 11403 is configured using an actuator, and moves the zoom lens and the focus lens of the lens unit 11401 by a predetermined distance along an optical axis under the control of the camera head control unit 11405. As a result, the magnification and the focus of an image captured by the imaging unit 11402 can be adjusted as appropriate.

The communication unit 11404 is configured using a communication device for transmission and reception of various types of information to and from the CCU 11201. The communication unit 11404 transmits an image signal obtained from the imaging unit 11402 as RAW data to the CCU 11201 via the transmission cable 11400.

In addition, the communication unit 11404 receives a control signal to control driving of the camera head 11102 from the CCU 11201, and supplies the control signal to the camera head control unit 11405. Examples of the control signal include information associated with imaging conditions such as information to specify a frame rate of a captured image, information to specify an exposure value at the time of capturing, and/or information to specify the magnification and focus of a captured image.

Note that the above imaging conditions such as the frame rate, the exposure value, the magnification, and the focus may be specified by a user as appropriate, or may be set automatically by the control unit 11413 of the CCU 11201 based on the acquired image signal. In the latter case, so-called auto exposure (AE) function, auto focus (AF) function, and auto white balance (AWB) function are installed in the endoscope 11100.

The camera head control unit 11405 controls driving of the camera head 11102 based on the control signal from the CCU 11201 received via the communication unit 11404.

The communication unit 11411 is configured using a communication device for transmission and reception of various types of information to and from the camera head 11102. The communication unit 11411 receives an image signal transmitted from the camera head 11102 via the transmission cable 11400.

In addition, the communication unit 11411 transmits a control signal to control driving of the camera head 11102 to the camera head 11102. The image signal and the control signal can be transmitted by telecommunication, optical communication, or the like.

The image processor 11412 performs various types of image processing on the image signal which is the RAW data transmitted from the camera head 11102.

The control unit 11413 performs various types of control related to capturing of a surgical site or the like by the endoscope 11100 and display of a captured image obtained by the capturing of the surgical site or the like. For example, the control unit 11413 generates a control signal to control driving of the camera head 11102.

In addition, the control unit 11413 causes the display device 11202 to display a captured image including a surgical site or the like based on an image signal subjected to image processing by the image processor 11412. At this time, the control unit 11413 may recognize various objects in the captured image using various image recognition techniques. For example, the control unit 11413 can recognize a surgical tool such as a forceps, a specific body site, bleeding, mist at the time of using the energy treatment tool 11112, and the like by detecting a shape, a color, or the like of an edge of an object included in the captured image. When causing the display device 11202 to display the captured image, the control unit 11413 may use a result of the recognition to superimpose various types of surgery support information on the image of the surgical site. Since the surgical support information is superimposed and presented to the surgeon 11131, it is possible to mitigate the burden on the surgeon 11131 and to allow the surgeon 11131 to reliably proceed with surgery.

The transmission cable 11400 that connects the camera head 11102 and the CCU 11201 is an electric signal cable compatible with communication of an electrical signal, an optical fiber compatible with optical communication, or a composite cable thereof.

Here, the communication is performed in a wired manner using the transmission cable 11400 in the illustrated example, but the communication between the camera head 11102 and the CCU 11201 may be performed wirelessly.

An example of the endoscopic surgery system to which the technology according to the present disclosure can be applied has been described above. The technology according to the present disclosure can be applied to the imaging unit 11402 of the camera head 11102 among the configurations described above. Specifically, the solid-state imaging device 1 of FIG. 1 can be applied to the imaging unit 11402. As the technology according to the present disclosure is applied to the imaging unit 11402, it is possible to suppress the occurrence of color mixing in the imaging unit 11402. Thus, a clearer surgical site image can be obtained so that the surgeon can reliably confirm the surgical site.

Note that the endoscopic surgery system has been described here as an example, but the technology according to the present disclosure may be applied to, for example, a microscopic surgery system or the like.

Although the above description is given regarding the embodiments of the present disclosure, the technical scope of the present disclosure is not limited to the above-described embodiments as they are, and various modifications can be made without departing from the scope of the present disclosure. In addition, the components in different embodiments and modifications can be combined suitably.

In addition, the effects described in the present specification are merely examples and are not restrictive of the disclosure herein, and other effects not described herein also can be achieved.

Note that the present technology can also have the following configurations.
(1) A solid-state imaging device comprising:
   a semiconductor layer provided with a plurality of photoelectric conversion units;
   a plurality of on-chip lenses that cause light to be incident on the corresponding photoelectric conversion units;
   a first separation region that separates the plurality of photoelectric conversion units on which light is incident through the same on-chip lens; and
   a second separation region that separates the plurality of photoelectric conversion units on which light is incident through the different on-chip lenses, wherein
   the first separation region has a higher refractive index than the second separation region.
(2) The solid-state imaging device according to (1) above, further comprising
   color filters of a plurality of colors provided between the semiconductor layer and the on-chip lenses, wherein
   the first separation region separates the plurality of photoelectric conversion units on which light is incident through the color filters of a same color, and
   the second separation region separates the plurality of photoelectric conversion units on which light is incident through the color filters of different colors.
(3) The solid-state imaging device according to (2) above, wherein
   the first separation region that separates the plurality of photoelectric conversion units on which light is incident through the color filter of red has a refractive index equal to a refractive index of the semiconductor layer.
(4) The solid-state imaging device according to any one of (1) to (3) above, wherein
   the first separation region and the second separation region do not penetrate the semiconductor layer.
(5) The solid-state imaging device according to any one of (1) to (3) above, wherein
   the first separation region does not penetrate the semiconductor layer, and
   the second separation region penetrates the semiconductor layer.
(6) The solid-state imaging device according to any one of (1) to (3) above, wherein
   the first separation region and the second separation region penetrate the semiconductor layer.
(7) The solid-state imaging device according to any one of (1) to (6) above, wherein
   the refractive index of the first separation region at a wavelength of 530 nm is 2.0 or more and less than 4.2.
(8) The solid-state imaging device according to any one of (1) to (7) above, wherein
   the refractive index of the second separation region at a wavelength of 530 nm is 1.0 or more and 1.5 or less.
(9) The solid-state imaging device according to any one of (1) to (8) above, wherein
   the first separation region contains a same material as a fixed charge film.
(10) The solid-state imaging device according to any one of (1) to (9) above, wherein
   an end of the first separation region on a light incident side has a higher refractive index than the second separation region, and
   a portion of the first separation region other than the end on the light incident side has a lower refractive index than the end on the light incident side.
(11) The solid-state imaging device according to (10) above, wherein
   a depth of the end of the first separation region on the light incident side is 20 nm or more and 100 nm or less.
(12) The solid-state imaging device according to any one of (1) to (11) above, wherein
   the first separation region has a smaller thickness than the second separation region.
(13) An electronic device comprising
   a solid-state imaging device including:
      a semiconductor layer provided with a plurality of photoelectric conversion units;
      a plurality of on-chip lenses that cause light to be incident on the corresponding photoelectric conversion units;
      a first separation region that separates the plurality of photoelectric conversion units on which light is incident through the same on-chip lens; and
      a second separation region that separates the plurality of photoelectric conversion units on which light is incident through the different on-chip lenses, wherein
   the first separation region having a higher refractive index than the second separation region.
(14) The electronic device according to (13) above, further including
   color filters of a plurality of colors provided between the semiconductor layer and the on-chip lenses, wherein
   the first separation region separates the plurality of photoelectric conversion units on which light is incident through the color filters of a same color, and
   the second separation region separates the plurality of photoelectric conversion units on which light is incident through the color filters of different colors.
(15) The electronic device according to (14) above, wherein
   the first separation region that separates the plurality of photoelectric conversion units on which light is incident through the color filter of red has a refractive index equal to a refractive index of the semiconductor layer.
(16) The electronic device according to any one of (13) to (15) above, wherein
   the first separation region and the second separation region do not penetrate the semiconductor layer.
(17) The electronic device according to any one of (13) to (15) above, wherein
   the first separation region does not penetrate the semiconductor layer, and
   the second separation region penetrates the semiconductor layer.
(18) The electronic device according to any one of (13) to (15) above, wherein
   the first separation region and the second separation region penetrate the semiconductor layer.
(19) The electronic device according to any one of (13) to (18) above, wherein
   the refractive index of the first separation region at a wavelength of 530 nm is 2.0 or more and less than 4.2.
(20) The electronic device according to any one of (13) to (19) above, wherein
   the refractive index of the second separation region at a wavelength of 530 nm is 1.0 or more and 1.5 or less.
(21) The electronic device according to any one of (13) to (20) above, wherein
   the first separation region contains a same material as a fixed charge film.
(22) The electronic device according to any one of (13) to (21) above, wherein
   an end of the first separation region on a light incident side has a higher refractive index than the second separation region, and
   a portion of the first separation region other than the end on the light incident side has a lower refractive index than the end on the light incident side.
(23) The electronic device according to (22) above, wherein
   a depth of the end of the first separation region on the light incident side is 20 nm or more and 100 nm or less.
(24) The electronic device according to any one of (13) to (23) above, wherein
   the first separation region has a smaller thickness than the second separation region.

### Reference Signs List

- 1: SOLID-STATE IMAGING DEVICE
- 10: PIXEL ARRAY UNIT
- 11: UNIT PIXEL
- 18: PIXEL GROUP
- 20: SEMICONDUCTOR LAYER
- 21: PHOTODIODE (EXAMPLE OF PHOTOELECTRIC CONVERSION UNIT)
- 22, 22A: FIRST SEPARATION REGION
- 22a: END ON LIGHT INCIDENT SIDE
- 22b: PORTION OTHER THAN END
- 23: SECOND SEPARATION REGION
- 30: FIXED CHARGE FILM
- 31: FIRST FIXED CHARGE FILM
- 32: SECOND FIXED CHARGE FILM
- 40: COLOR FILTER
- 40R: RED FILTER (EXAMPLE OF RED COLOR FILTER)
- 50: ON-CHIP LENS
- 100: ELECTRONIC DEVICE

## Claims

1. A solid-state imaging device comprising:
a semiconductor layer provided with a plurality of photoelectric conversion units;
a plurality of on-chip lenses that cause light to be incident on the corresponding photoelectric conversion units;
a first separation region that separates the plurality of photoelectric conversion units on which light is incident through the same on-chip lens; and
a second separation region that separates the plurality of photoelectric conversion units on which light is incident through the different on-chip lenses, wherein
the first separation region has a higher refractive index than the second separation region.

2. The solid-state imaging device according to claim 1, further comprising
color filters of a plurality of colors provided between the semiconductor layer and the on-chip lenses, wherein
the first separation region separates the plurality of photoelectric conversion units on which light is incident through the color filters of a same color, and
the second separation region separates the plurality of photoelectric conversion units on which light is incident through the color filters of different colors.

3. The solid-state imaging device according to claim 2, wherein
the first separation region that separates the plurality of photoelectric conversion units on which light is incident through the color filter of red has a refractive index equal to a refractive index of the semiconductor layer.

4. The solid-state imaging device according to claim 1, wherein
the first separation region and the second separation region do not penetrate the semiconductor layer.

5. The solid-state imaging device according to claim 1, wherein
the first separation region does not penetrate the semiconductor layer, and
the second separation region penetrates the semiconductor layer.

6. The solid-state imaging device according to claim 1, wherein
the first separation region and the second separation region penetrate the semiconductor layer.

7. The solid-state imaging device according to claim 1, wherein
the refractive index of the first separation region at a wavelength of 530 nm is 2.0 or more and less than 4.2.

8. The solid-state imaging device according to claim 1, wherein
the refractive index of the second separation region at a wavelength of 530 nm is 1.0 or more and 1.5 or less.

9. The solid-state imaging device according to claim 1, wherein
the first separation region contains a same material as a fixed charge film.

10. The solid-state imaging device according to claim 1, wherein
an end of the first separation region on a light incident side has a higher refractive index than the second separation region, and
a portion of the first separation region other than the end on the light incident side has a lower refractive index than the end on the light incident side.

11. The solid-state imaging device according to claim 10, wherein
a depth of the end of the first separation region on the light incident side is 20 nm or more and 100 nm or less.

12. The solid-state imaging device according to claim 1, wherein
the first separation region has a smaller thickness than the second separation region.

13. An electronic device comprising
a solid-state imaging device including:
a semiconductor layer provided with a plurality of photoelectric conversion units;
a plurality of on-chip lenses that cause light to be incident on the corresponding photoelectric conversion units;
a first separation region that separates the plurality of photoelectric conversion units on which light is incident through the same on-chip lens; and
a second separation region that separates the plurality of photoelectric conversion units on which light is incident through the different on-chip lenses, wherein
the first separation region having a higher refractive index than the second separation region.
